# EUROPEAN PATENT APPLICATION

(11) **EP 4 336 546 A1**
(43) Date of publication of application: **13.03.2024**
(21) Application number: 23193410.0
(22) Date of filing: 25.08.2023
(51) Int. Cl.: H01L 21/768, H01L 23/532, H01L 23/00

(54) **SEMICONDUCTOR PACKAGE OR DEVICE WITH SEALING LAYER**

(30) Priority: 09.09.2022 US 202217941886
(71) Applicant: STMicroelectronics S.r.l., 20864 Agrate Brianza (MB) (IT)
(72) Inventor: MILANESI, Francesca, 20161 MILANO (IT); COLPANI, Paolo, 20864 AGRATE BRIANZA (MB) (IT)
(74) Representative: Studio Torta S.p.A.

(57) **Abstract**

The present invention is directed to embodiments of a conductive structure on a conductive layer, which may be a conductive damascene layer of a semiconductor device or package. The conductive damascene layer may be within a substrate of the semiconductor device or package. A crevice is present between one or more sidewalls of the conductive structure and one or more sidewalls of one or more insulating layers on the substrate and extends to a surface of the conductive layer. A sealing layer is formed in the crevice that seals the conductive layer from moisture and contaminants external to the semiconductor device or package that may enter the crevice. In other words, the sealing layer stops the moisture and contaminants from reaching the conductive layer such that the conductive layer does not corrode due to exposure to the moisture and contaminants.

## Description

### BACKGROUND

### Technical Field

The present invention is directed to a semiconductor structure, which may be present within a semiconductor device, including a sealing layer to protect a conductive layer.

### Description of the Related Art

Generally, semiconductor devices include conductive layers For example, in some semiconductor devices, a top conductive layer (*e.g.,* a top metallization layer) of the semiconductor devices may be connected in a proper way to a semiconductor package to guarantee input/output (I/O) electrical signal continuity among package pins and the semiconductor devices. These connections may be realized between the top conductive layer and the semiconductor package through a top metal passivation opening, which may be called a PAD. The PAD may be finished to contain and include a conductive structure formed by a dedicated metallization process, which may be referred to as an over pad metallization (OPM) process. After completion of semiconductor manufacturing process of the semiconductor device and before packaging of the semiconductor device, the PAD, at which the top conductive layer and the conductive structure are present, of the semiconductor device may remain, in a controlled environment, unprotected during several operations, such as electrical testing, electrical wafers sorting (EWS), wafer shipping to assembly FAB (the fab where the device package is realized) and other similar or like type of processes. During these processes, as the PAD remains exposed, the top conductive layer and the conductive structure at the PAD may be corroded by a presence of environmental contamination such as moisture (*e.g.,* droplets, humidity, etc.) or contaminants (*e.g.,* contaminant particles, etc.) that may corrode the top conductive layer and the conductive structure present at the PAD. When the top conductive layer and/or the conductive structure at the PAD is exposed to these environmental contaminants, the top conductive layer and/or the conductive structure at the PAD may corrode more quickly than expected resulting in the usable lifespan of the semiconductor packages or devices to be reduced as the semiconductor packages or devices may malfunction earlier than expected.

In the semiconductor devices or packages, the conductive structure (*e.g.,* contact pad or structure, which may be formed utilizing the OPM process) may be coupled to the top conductive layer used in the semiconductor devices or packages such as a redistribution layer (RDL) or coupled to a wire bond (*e.g.,* ball and stich, etc.). However, forming the conductive structure with the OPM process at the PAD (*e.g.,* in the top metal passivation opening) may result in forming an open pathway (*e.g.,* a crevice) between the conductive structure and passivation layers that may allow for environmental contaminants to more readily corrode the conductive structure and/or the top conductive layer For example, this open pathway may be formed due to poor adhesion between the conductive structure, which may be formed by the OPM process, and passivation layers that are adjacent to the conductive structure. Thermal expansion and intrinsic stresses during the OPM process to form the conductive structure, or may result in the formation of the open pathway (*e.g.,* crevice).

### BRIEF SUMMARY

The present invention relates to a device and a method, as defined in the annexed claims.

In general terms, the present disclosure can be summarized as it follows.

The present disclosure is directed to at least some embodiments of structures and sealing layers that may be utilized in manufacturing semiconductor devices with a top conductive layer (*e.g.,* first or top metallization layer). The top conductive layer may a layer of copper (Cu) or a layer of aluminum (Al), which may be protected by an over pad metallization (OPM) formed conductive structure formed on a surface of the top conductive layer. The present disclosure is directed to forming a sealing layer between the conductive structure and other various layers of the semiconductor devices when manufacturing the semiconductor devices to reduce the likelihood of corrosion in the top conductive layer and the conductive structure.

The present disclosure is directed to at least some embodiments of structures, which may be utilized within semiconductor packages or devices, including conductive structures and sealing layers in accordance with embodiments of the present disclosure. These structures have a reduced likelihood of being corroded due to moisture and contaminants present in an external environment. For example, the sealing layer may block or prevent environmental contaminants from reaching a conductive layer adjacent to an open pathway (*e.g.,* crevice) through which environmental contaminants may readily enter. These environmental contaminants may include moisture (*e.g.,* droplets, humidity, etc.) or may be other contaminants (*e.g.,* contaminant particles) within an external environment. The open pathway (*e.g.,* crevice) may be formed due to poor adhesion between the conductive structures, which may be formed by the OPM process, and passivation layers that are adjacent to the conductive structures. Thermal expansion and intrinsic stresses during the OPM process to form the conductive structures may result in the formation of the open pathway (*e.g.,* crevice). The sealing layers through prevent the environmental contaminants from reaching the conductive layers to reduce the likelihood of early corrosion of the conductive layers.

In some embodiments, a substrate includes a first surface at which a conductive layer within the substrate is exposed. The conductive layer may be a conductive damascene layer within the substrate. The conductive layer includes a second surface that is exposed from the first surface of the substrate. A first insulating layer is on the first surface of the substrate and has a first sidewall that is transverse to the first surface of the substrate and is transverse to the second surface of the conductive layer. A first opening is in the first insulating layer and extends through the first insulating layer to the second surface of conductive layer such that the first opening exposes the second surface of the conductive layer from the first insulating layer. A conductive structure is present within the first opening and is coupled to the second surface of the conductive layer. The first insulating layer further includes a first sidewall that is adjacent to the first opening, and the conductive structure includes a second sidewall that faces the first sidewall and is spaced apart from the first sidewall of the first insulating layer. A crevice is between the first sidewall of the first insulating layer and the second sidewall of the conductive structure. The crevice extends along the first sidewall of the first insulating layer and the second sidewall of the conductive structure to the second surface of the conductive layer. A sealing layer is within the crevice and is on the second surface of the conductive structure to seal the second surface of the conductive structure from an environment external to the crevice.

The sealing layer acts as a barrier to stop moisture and contaminants from reaching the second surface of the conductive layer. For example, while moisture and contaminants may readily enter the crevice and pass through the crevice to the sealing layer, the moisture and contaminants cannot reach the second surface of the conductive layer as the sealing layer stops and blocks the moisture and contaminants. This at least reduces the likelihood of the conductive layer corroding or being damaged from moisture and contaminants from an external environment in fluid communication with the crevice. Reducing this likelihood of corrosion or damage generally results in increasing a yield of usable semiconductor packages that are manufactured within tolerance utilizing a semiconductor fabrication plant (FAB).

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility:
Figure 1 is a cross-sectional view of a finishing structure according to the known art;
Figure 2 is a cross-sectional view of an embodiment of a structure of the present invention;
Figure 3 is a cross-sectional view of an embodiment of a structure of the present invention;
Figure 4 is a cross-sectional view of an embodiment of a structure of the present invention;
Figure 5 is a cross-sectional view of an embodiment of a structure of the present invention;
Figure 6 is a cross-sectional view of an embodiment of a structure of the present invention;
Figure 7A is a zoomed in enhanced view of an embodiment of section 7-7 as shown in Figure 2 of the present invention;
Figure 7B is a zoomed in enhanced view of an alternative embodiment of section 7-7 as shown in Figure 2 of the present invention;
Figure 7C is a zoomed in enhanced view of another alternative embodiment of section 7-7 as shown in Figure 2 of the present invention;
Figures 8A-8D are cross-sectional views of an embodiment of a method of manufacturing the embodiment of the structure as shown in Figure 2 of the present invention;
Figure 9 is a cross-sectional view of an embodiment of a method of manufacturing the embodiment of the structure as shown in Figure 3 of the present invention;
Figures 10A and 10B are cross-sectional views of an embodiment of a method of manufacturing the embodiment of the structure as shown in Figure 4 of the present invention;
Figure 11 is a cross-sectional view of an embodiment of a method of manufacturing the embodiment of the structure as shown in Figure 5;
Figures 12A and 12B are directed to an embodiment of a method of manufacturing the embodiment of the structure as shown in Figure 6 of the present invention;
Figure 13 is a cross-sectional view of an embodiment of a method of manufacturing of the present invention;
Figure 14 is a cross-sectional view of an embodiment of a method of manufacturing of the present invention;
Figure 15 is a cross-sectional view of an embodiment of a method of manufacturing of the present invention;
Figure 16 is a cross-sectional view of an embodiment of a method of manufacturing of the present invention;
Figure 17 is a cross-sectional view of an embodiment of a method of manufacturing of the present invention; and
Figure 18 is a cross-sectional view of an embodiment of a method of manufacturing of the present invention.

### DETAILED DESCRIPTION

In the following description, certain specific details are set forth in order to provide a thorough understanding of various embodiments of the invention. However, one skilled in the art will understand that the invention may be practiced without these specific details. In other instances, well-known structures associated with electronic components, packages, and semiconductor fabrication techniques have not been described in detail to avoid unnecessarily obscuring the descriptions of the embodiments of the present invention.

Unless the context requires otherwise, throughout the specification and claims that follow, the word "comprise" and variations thereof, such as "comprises" and "comprising," are to be construed in an open, inclusive sense, that is, as "including, but not limited to."

The use of ordinals such as first, second, third, etc., does not necessarily imply a ranked sense of order, but rather may only distinguish between multiple instances of an act or a similar structure or material.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The terms "top," "bottom," "upper," "upper most," "lower," "lower most," "left," "right," "vertical," and "horizontal" are used for only discussion purposes based on the orientation of the components in the discussion of the figures in the present invention as follows. These terms are not limiting as to the possible positions explicitly disclosed, implicitly disclosed, or inherently disclosed in the present invention.

The term "substantially" is used to clarify that there may be slight differences and variations when a package is manufactured in the real world, as nothing can be made perfectly equal or perfectly the same. In other words, "substantially" means and represents that there may be some slight variation in actual practice and instead is made or manufactured within selected tolerances.

As used in this specification and the appended claims, the singular forms "a," "an," and "the" include plural referents unless the content clearly dictates otherwise.

The present invention is directed to at least some embodiments of PAD structures (*e.g.,* conductive structures, which include Nickel (Ni) and Palladium (Pd) in some embodiments) that can be utilized during semiconductor manufacturing of electronic devices (*e.g.,* semiconductor devices, semiconductor devices that may be utilized in semiconductor packages, or some other similar or like type of electronic device or devices) to reduce the likelihood of corrosion of conductive materials or layers within the electronic devices. In some embodiments, a sealing layer is provided to seal off a conductive layer from a gap or open pathway (*e.g.,* crevice) that has been formed when forming a conductive structure at a PAD with an over pad metallization (OPM) process within a semiconductor device. The sealing layer prevents or blocks environmental contaminants (*e.g.,* moisture, contaminant particles, etc.) in an environment external to the semiconductor device that is being manufactured from reaching the conductive layer. For example, the sealing layer blocks moisture and contaminants from the external environment reaching the conductive layer. Accordingly, the sealing layer acts as a barrier that reduces the likelihood of corrosion in the conductive layer due to exposure to the moisture and contaminants from the external environment. In other words, the sealing layer seals the conductive layer from being exposed to the moisture and contaminants within the external environment.

In some embodiments, the sealing layer is formed to cover the conductive structure as well as within the gap or open pathway (*e.g.,* crevice) to prevent corrosion of the conductive structure and the conductive layer when the semiconductor device is being stored within a controlled environment, which contains environmental contaminants (*e.g.,* moisture, contaminant particles, etc.), and awaiting further processing or testing. For example, this further processing or testing includes electrical testing, electrical wafers sorting (EWS), wafer shipping to assembly FAB (the fab where the device package is realized) and other similar or like type of processes. Furthermore, during these processes, as the conductive structure and conductive layer remain sealed off by the sealing layer from the external environment external to the semiconductor device being manufactured, the conductive layer and the conductive structure at the PAD are protected from the environmental contaminants such that the likelihood of corrosion due to the environmental contaminants within the external environment is reduced.

Reducing this likelihood of corrosion or damage generally results in increasing a yield of usable semiconductor packages that are manufactured within tolerance utilizing a semiconductor fabrication plant (FAB). This corrosion can occur during semiconductor device manufacturing processes and tests that are utilized to form different types of final semiconductor or electronic devices. For example, these processes and tests include steps like parametric tests (PT), electrical wafer sorting (EWS), shipping processes to assembly line for semiconductor package manufacturing, or other similar or like types of processes known within the semiconductor industry. These processes have associated storage time of these semiconductor devices as these semiconductor devices are being manufactured that can increase the likelihood of exposure to contamination that may result in corrosion of the semiconductor device as the semiconductor device is being manufactured through the crevice, gap, or open pathway that may have been generated when forming conductive structure at the PAD, which may be due to the forming the conductive structure with the OPM process. As will be readily appreciated in view of the following discussion, it is not trivial to include a sealing layer or layers of the present invention that seal the crevice, gap, or open pathway, and at the same time maintaining the functionality of the conductive structure at the PAD to be assembled and rightly connected with a conductive layer (*e.g.,* metallization layer) during device and packaging formation steps, processes, and test, for example, wire bonding steps, solder bump formation steps, or other similar or like interconnection formation steps, processes, or tests to connect input/output (I/O) pins with the semiconductor device. In other words, the sealing layer or layers of the present invention act as a barrier and blocks or stops the moisture and contaminants that entered the crevice and traveled along the crevice to the sealing layer from reaching the conductive layer. This at least reduces the likelihood of the conductive layer being corroded or damaged by being exposed to the moisture and contaminants. By reducing the likelihood of corrosion or damage of the conductive layer while manufacturing the semiconductor device or electronic devices (*e.g.,* in the FAB), the yield of usable semiconductor or electronic devices that are manufactured within selected or preferred tolerances is increased.

After the electronic devices are manufactured, the sealing layer is still present on the conductive layer such that the moisture and contaminants from the external environment outside the electronic devices may not readily reach the conductive layer. This increases the resistance and the robustness in the electronic devices with the sealing layer against corrosion and damage due to the moisture and contaminants within the external environment relative to an electronic device that does not include the sealing layer.

In view of the above discussion, the sealing layer reduces the likelihood of corrosion and damage in the conductive layer due to exposure to moisture and contaminants from an external environment external to the conductive layer or external to the electronic device. The sealing layer reduces the likelihood of corrosion and damage in the conductive layer increasing a yield of usable electronic devices manufactured and improves the resistance and robustness of the electronic devices that are manufactured with the sealing layer against corrosion and damage that may be caused by the moisture and contaminants within the external environment.

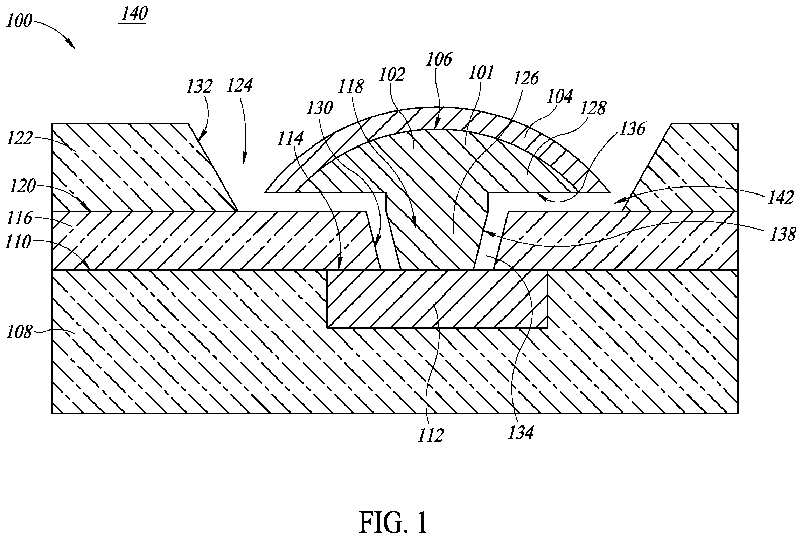

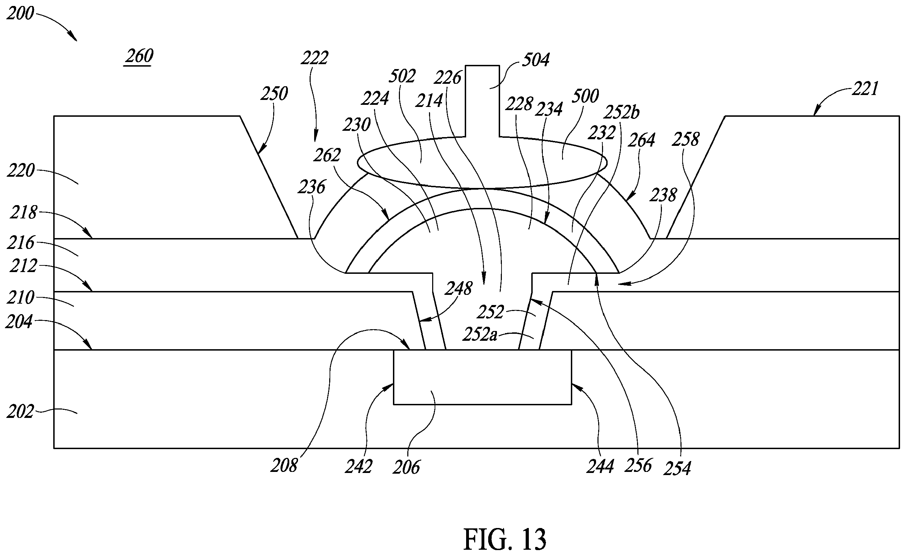

Figure 1 is directed to a cross-sectional view of a structure 100, which has a stacked configuration, including a conductive structure 101 that may be utilized within an electronic device (*e.g.,* a semiconductor package, a semiconductor device, or some other similar or like type of electronic device). For example, the conductive structure 101 is a contact pad or a contact structure of a semiconductor die, a printed circuit board (PCB), or some other similar or like type of electrical device, component, or structure of the electronic device. Other conductive structures or layers (see Figures 13-18 of the present invention) are coupled to form electrical connections or pathways within the electronic device in which the structure 100 and the conductive structure 101 are present.

The conductive structure 101 includes a first conductive layer 102 and a second conductive layer 104 that is on and covers a surface 106 of the first conductive layer 102. The second conductive layer 104 is thinner relative to the first conductive layer 102. As shown in Figure 1, the surface 106 is curved.

A substrate 108 of the structure 100 includes a surface 110. A conductive layer 112 is, in an embodiment, a layer of the substrate 108. As shown in Figure 1, the conductive layer 112 is in the substrate 108. The conductive layer 112 includes a surface 114 that is exposed from the surface 110 of the substrate 108. The conductive structure 101 is on and coupled to the surface 114 of the conductive layer 112. While not shown, the substrate 108 may include multiple dielectric layers, multiple passivation layers, multiple conductive layers, or may include any number of layers of similar or like materials that may be utilized to form the substrate 108.

A first insulating layer 116 is on the surface 110 of the substrate 108 and the surface 114 of the conductive layer 112. The first insulating layer 116 is in particular a passivation layer, a dielectric layer, a polyimide layer, or some other similar or like type of layer that includes an insulating material or includes a non-conductive material. For example, the first insulating layer 116 is a silicon nitride (SiN) layer.

A first opening 118 is within and extends through the first insulating layer, and the conductive structure 101 is present within the first opening 118. The conductive structure 101 extends through the first opening 118 to the surface 114 of the conductive layer 112 such that the conductive structure 101 is on and coupled to the surface 114 of the conductive layer 112. A surface 120 of the insulating layer 116 faces away from the surface 110 of the substrate 108 and faces away from the surface 114 of the conductive layer 112.

A second insulating layer 122 is on the surface 120 of the first insulating layer 116. The second insulating layer 122 is in particular a passivation layer, a dielectric layer, a polyimide layer, or some other similar or like type of layer that includes an insulating material or includes a non-conductive material. For example, the second insulating layer 122 is a polyimide material.

A second opening 124 is within the second insulating layer 122 and extends through the second insulating layer 122 to the first opening 118 in the first insulating layer 116. The second opening 124 overlaps the first opening 118 within the first insulating layer 116 such that the conductive structure 101 extends through the second opening 124 in the second insulating layer 122 and the first opening 118 in the first insulating layer 116 to the surface 114 of the conductive layer 112. The conductive structure 101 includes a first portion 126 that extends into and through the first opening 118 and a second portion 128 that is present within the second opening 124. The second portion 128 of the conductive structure 101 is transverse to the first portion 126 of the conductive structure, and the second portion 128 of the conductive structure 101 is wider than the first portion 126 of the conductive structure 101.

The first insulating layer 116 includes a first sidewall 130 that is adjacent to the first opening 118 in the first insulating layer 116. When the first opening 118 is a round opening (*e.g.,* circular, ovular, ellipsoidal, etc.), the first sidewall 130 extends around and surround the first opening 118 in the first insulating layer 116. The second insulating layer 122 includes a second sidewall 132 that is adjacent to the second opening 124. When the second opening 124 is a round opening (*e.g.,* circular, ovular, ellipsoidal, etc.), the second sidewall 132 extends around and surround the second opening 124 in the second insulating layer 122. As shown in Figure 1, the first sidewall 130 of the first insulating layer 116 is transverse or angled relative to the surface 114 of the conductive layer 112, and the second sidewall 132 of the second insulating layer 122 is transverse or angled relative to the surface 120 of the first insulating layer 116.

A crevice 134 extends around the conductive structure 101 and extends along a surface 136 of the conductive structure 101 and a sidewall 138 of the conductive structure 101 that is transverse to the surface 136 of the conductive structure 101. The crevice 134 surrounds the first portion 126 of the conductive structure 101. The crevice 134 is between the surface 136 of the conductive structure 101 and the surface 120 of the first insulating layer 116. The surface 120 of the first insulating layer 116 faces away from the surface 110 of the substrate 108. The crevice 134 is between the sidewall 138 of the conductive structure 101 and the first sidewall 130 of the first insulating layer 116. The sidewall 138 of the conductive structure 101 faces towards the first sidewall 130 of the first insulating layer 116, and the first sidewall 130 of the first insulating layer 116 faces towards the sidewall 138 of the conductive structure 101. The crevice 134 extends continuously along the first sidewall 130 of the first insulating layer 116, the sidewall 138 of the conductive structure 101, the surface 120 of the first insulating layer 116, and the surface 136 of the conductive structure 101 as shown in Figure 1. The crevice 134 exposes a portion of the surface 114 of the conductive layer 112 such that the surface 114 of the conductive layer 112 is not fully covered by the conductive structure 101. As the portion of the surface 114 of the conductive layer 112 is exposed by the crevice 134, moisture (*e.g.,* gases, liquids, fluids, etc.) and contaminants (*e.g.,* chemicals, particles, etc.) that enter into the crevice 134 from an external environment 140 through a crevice opening 142 is exposed to the surface 114 of the conductive layer. The crevice opening 142 is in fluid communication with the second opening 124 in the second insulating layer 122, and, therefore, the crevice opening 142 is in fluid communication with the external environment 140 through the second opening 124 in the second insulating layer 122. This exposure of the surface 114 of the conductive layer 112 to the moisture and contaminants from the external environment 140 through the crevice opening 142 and the crevice 134 results in an increased likelihood of the conductive layer 112 corroding, which may result in the electronic device (*e.g.,* semiconductor package, semiconductor device, etc.) including the conductive structure 101 becoming defective or less efficient.

However, the crevice 134 may be present to reduce the likelihood of mechanical issues or defects of the conductive structure 101 and the first and second insulating layers 116, 122 when coupling a conductive structure, layer, or wire bond to the conductive structure 101. For example, when a wire bond (*e.g.,* ball and stitch) is coupled to the conductive structure 101 through a wire bond formation technique, the conductive structure 101 expands into the crevice 134 such that the surface 136 of the conductive structure 101 moves closer to the surface 120 of the first insulating layer 116 and the sidewall 138 of the conductive structure 101 moves closer to the first sidewall 130 of the first insulating layer 116. The crevice 134 provides clearance such that the surface 136 of the conductive structure 101 does not physically contact the surface 120 of the first insulating layer 116 and such that the sidewall 138 of the conductive structure 101 does not physically contact the first sidewall 130 of the first insulating layer due to this expansion of the conductive structure 101. If the surface 136 and sidewall 138, respectively, of the conductive structure 101 were to physically contact and apply pressure to the surface 120 and the first sidewall 130, respectively, of the first insulating layer 116, mechanical issues or defects may propagate within the conductive structure 101 or the first insulating layer 116. For example, the conductive structure 101 or the first insulating layer 116 may become deformed such that the moisture and contaminants from the external environment 140 may more readily reach conductive features and structures (*e.g.,* the surface 114 of the conductive layer 112) present within the electronic device (*e.g.,* semiconductor device, semiconductor package, etc.). This exposure of the moisture and contaminants to the conductive structures and features within the electronic device may result in the conductive features and structures (*e.g.,* the surface 114 of the conductive layer 112) corroding such that the electronic device either being manufactured or already manufactured becomes defective such that the electronic device does not function within preferred or expected tolerances.

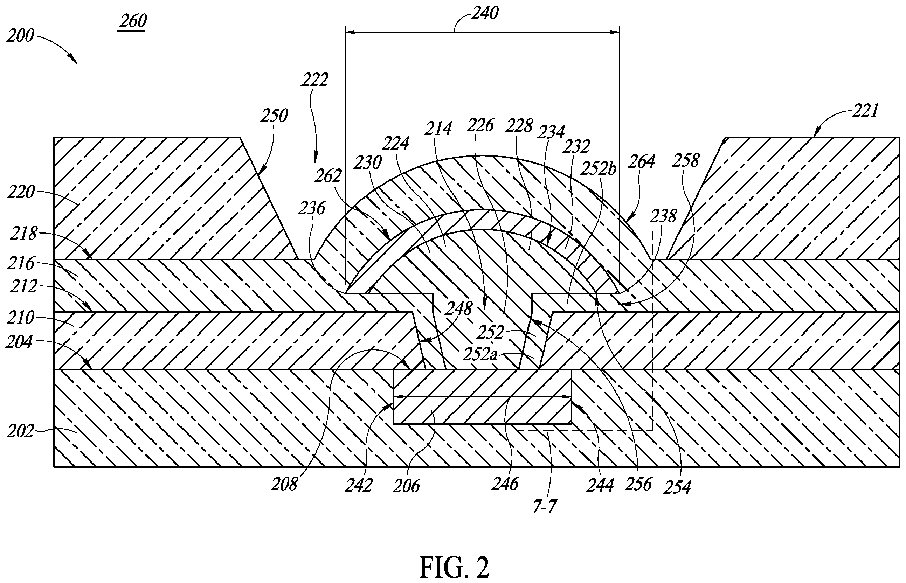

In view of the above discussion, the present invention is directed to providing sealing layers between various layers of electronic devices (*e.g.,* semiconductor devices, semiconductor packages, etc.) to reduce or stop penetration of external moisture and contaminants in order to provide reduced likelihood of corrosion due to external moisture and contaminants from an external environment while also providing a reduced likelihood of mechanical issues or defects. For example, the sealing layers 216, 408 at least as shown in Figures 2-6 reduce the likelihood of respective conductive layers, features, and structures within electronic devices (*e.g.,* semiconductor packages, semiconductor devices, etc.) in which the sealing layers 216, 408 are present.

Figure 2 is a cross-sectional view of an embodiment of a structure 200 that may be utilized within an electronic device (*e.g.,* a semiconductor device, semiconductor package, etc.), in accordance with at least some embodiments of the present invention. The structure 200 has a stacked configuration based on the orientation as shown in Figure 2.

A substrate 202 of the structure 200 includes a surface 204, and a conductive layer 206 is exposed from the surface 204 of the substrate 202. The conductive layer 206 includes a surface 208 that is exposed from the surface 204 of the substrate 202. The conductive layer 206 is in electrical communication with other conductive layers and features within the substrate 202. For example, the conductive layer 206 is coupled or in electrical communication with conductive traces, conductive lines, conductive vias, or other similar or like conductive features (not shown) within the substrate 202. In other words, the conductive layer 206 is a portion of electrical pathways defined by multiple conductive layers, structures, or features within the substrate 202.

The conductive layer 206 is in particular a damascene conductive layer within the substrate 202. For example, the conductive layer 206 is formed utilization a damascene layer formation technique. The conductive layer 206 includes, in particular, a copper material, a copper alloy material, a silver material, a gold material, or some other similar or like type of conductive material that may be utilized to form the conductive layer 206.

A first insulating layer 210 is on the surface 204 of the substrate 202 and is on the surface 208 of the conductive layer 206. The first insulating layer 210 is in particular a passivation layer, a dielectric layer, a polyimide layer, or some other similar or like type of layer that includes an insulating material or includes a non-conductive material. For example, the first insulating layer 210 is a silicon nitride layer. The first insulating layer 210 includes a surface 212 that faces away from the surface 204 of the substrate 202. In some embodiments, the first insulating layer 210 is multiple insulating layers stacked on each other.

A first opening 214 extends through the first insulating layer 210 to the conductive layer. The first opening 214 extends from the surface 212 of the first insulating layer 210 to the surface 208 of the conductive layer 206. The first opening 214 only partially exposes the surface 208 of the conductive layer 206 from the first insulating layer 210 such that a central region of the surface 208 of the conductive layer 206 is exposed by the first opening 214, whereas a peripheral region of the surface 208 of the conductive layer 206 is covered by the first insulating layer 210. The first insulating layer 210 completely and entirely covers the surface 204 of the substrate 202. In some embodiments, the first insulating layer 210 is made of one or more insulating layers stacked on each other.

A sealing layer 216 is on the first insulating layer 210 and is on the surface 212 of the first insulating layer 210. The sealing layer 216 has a thickness greater than 5-nanometers, less than 5-nanometers, or substantially equal to 5-nanometers, for example, the thickness may range from 3-nanometers to 100-nanometers. The sealing layer 216 is in particular a moisture resistant or proof material that moisture (*e.g.,* gases, fluids, liquids, etc.) may not readily pass through or permeate, and the sealing layer 216 can include an insulating material. For example, the sealing layer 216 may include hafnium (*e.g.,* hafnium aluminum oxide, hafnium oxide, etc.), aluminum (*e.g.,* aluminum oxide, etc.), or some other type of similar or like type of material. For example, a hafnium oxide material can be utilized for the sealing layer 216 as the hafnium oxide material can be more resistant against corrosion relative to an aluminum oxide material, an aluminum oxide material can be utilized as aluminum oxide adheres more readily to a conductive material (*e.g.,* the conductive structure 224) relative to a hafnium oxide material, and a hafnium aluminum oxide material can be utilized to balance the greater adhesion of the aluminum oxide material and the greater resistance of the hafnium oxide material.

The sealing layer 216 includes a surface 218 that faces away from the surface 204 of the substrate 202 and faces away from the surface 212 of the first insulating layer 210. In some embodiments, the sealing layer 216 completely and entirely covers the surface 212 of the first insulating layer 210. The sealing layer 216 is a material that can be formed utilizing a very conformal deposition technique such as an atomic layer deposition (ALD) techniques or processes with equivalent conformality or gap filling performances. An alternative includes dispensing utilizing a liquid source.

A second insulating layer 220 is on the sealing layer 216 and is on the surface 218 of the sealing layer 216. The second insulating layer 220 is in particular a passivation layer, a dielectric layer, a polyimide layer, or some other similar or like type of layer that includes an insulating material or includes a non-conductive material. For example, the second insulating layer 122 is a polyimide material. In some embodiments the second insulating layer 220 is completely and entirely separated from the first insulating layer 210 by the sealing layer 216. For example, as shown in Figure 2, the sealing layer 216 is between the first insulating layer 210 and the second insulating layer 220 such that the sealing layer 216 separates the first insulating layer 210 from the second insulating layer 220. The second insulating layer 220 includes a surface 221 that faces away from the surface 204 of the substrate 202, faces away from the surface 212 of the first insulating layer 210, and faces away from the surface 218 of the sealing layer 216. In some embodiments, the second insulating layer 220 includes multiple insulating layers stacked on each other.

In some embodiments of the structure 200, the second insulating layer 220 may not be present such that the surface 218 of the sealing layer 216 is not covered by the second insulating layer 220, and, instead, a resin, molding compound, or an epoxy is present on the surface 218 of the sealing layer 216. For example, after the sealing layer 216 is formed on the surface 212 of the first insulating layer 210 and is formed in the crevice 252, a resin, molding compound, or an epoxy is formed on the sealing layer 216 instead of the second insulating layer 220, which in some embodiments is a polyimide material. In other words, the second insulating layer 220 is optional in some alternative embodiments of the structure 200 as shown in Figure 2.

A second opening 222 extends through the second insulating layer 220 to the sealing layer 216. The second opening 222 in the second insulating layer 220 is aligned with and overlaps the first opening 214 in the first insulating layer 210. The second opening 222 is wider than the first opening 214 based on the orientation as shown in Figure 2. For example, when the first and second openings 214, 222, respectively, are both round openings (*e.g.,* circular, ovular, ellipsoidal, etc.), the second opening 222 generally has a diameter larger than a diameter of the first opening 214.

The second opening 222 exposes at least a portion of the sealing layer 216 from the second insulating layer 220. In other words, as shown in Figure 2, the second insulating layer 220 does not cover the portion of the sealing layer 216 that is aligned with and overlapped by the second opening 222 such that the portion of the sealing layer 216 from the second insulating layer 220 is exposed.

A conductive structure 224 is on the surface 208 of the conductive layer 206 and is coupled to the surface 208 of the conductive layer 206. The conductive structure 224 is present within the first opening 214 in the first insulating layer 210 and extends through the first opening 214 in the first insulating layer 210 to the surface 208 of the conductive layer 206. The conductive structure 224 includes a first portion 226 that extends through the first opening 214 in the first insulating layer 210 to the surface 208 of the conductive layer 206, and a second portion 228 that is transverse to the first portion 226 of the conductive structure 224 and extends outward from the first portion 226 of the conductive structure 224. The conductive structure 224 is a contact pad or a contact structure of a semiconductor die, a printed circuit board, a semiconductor device, or some other similar or like type of electronic device in which the conductive structure 224 is present.

The conductive structure 224 further includes a first conductive layer 230 and a second conductive layer 232 that is on and covers a surface 234 of the first conductive layer 230. The second conductive layer 232 is thinner relative to the first conductive layer 230. As shown in Figure 1, the surface 234 of the first conductive layer 230 is curved.

A first point 236 is at a left-hand side of the second portion 228 of the conductive structure 224 based on the orientation as shown in Figure 2. A second point 238 is at a right-hand side of the second portion 228 of the conductive structure 224 based on the orientation as shown in Figure 2. The first point 236 is opposite to the second point 238. In some embodiments, when the second portion 228 of the conductive structure 224 is substantially round (*e.g.,* circular, ovular, ellipsoidal, etc.), the first point 236 and the second point 238 are along a round edge (*e.g.,* circular, ovular, ellipsoidal, etc.) of the conductive structure 224. A dimension 240 extends from the first point 236 to the second point 238.

A first end 242 of the conductive layer 206 is opposite to a second end 244 of the conductive layer 206. A dimension 246 extends from the first end 242 to the second end. As shown in Figure 2, the dimension 246 of the conductive layer 206 is less than the dimension 240 of the second portion 228 of the conductive structure 224. As the dimension 240 of the second portion 228 is greater than the dimension 246 of the conductive layer 206, the conductive structure 224 fully overlaps and covers the surface 208 of the conductive layer 206. In some embodiments, the dimension 240 of the second portion 228 of the conductive structure 224 is less than the dimension 246 such that the conductive structure 224 does not fully or completely overlap and cover the surface 208 of the conductive layer 206.

A first sidewall 248 of the first insulating layer 210 is adjacent to the first opening 214. When the first opening 214 is a round opening (*e.g.,* circular, ovular, ellipsoidal, etc.), the first sidewall 248 extends around and surround the first opening 214 in the first insulating layer 210. The second insulating layer 220 includes a second sidewall 250 that is adjacent to the second opening 222. When the second opening 222 is a round opening (*e.g.,* circular, ovular, ellipsoidal, etc.), the second sidewall 250 extends around and surround the second opening 222 in the second insulating layer 220. As shown in Figure 2, the first sidewall 248 of the first insulating layer 210 is transverse or angled relative to the surface 208 of the conductive layer 206, and the second sidewall 250 of the second insulating layer 220 is transverse or angled relative to the surface 218 of the sealing layer 216.

A crevice 252 extends around the conductive structure 224 and extends along a surface 254 of the conductive structure 224 and a sidewall 256 of the conductive structure 224 that is transverse to the surface 254 of the conductive structure 224. The crevice 252 surrounds the first portion 226 of the conductive structure 224. The crevice 252 is between the surface 254 of the conductive structure 224 and the surface 212 of the first insulating layer 116. The surface 212 of the first insulating layer 210 faces away from the surface 204 of the substrate 202. The crevice 252 is between the sidewall 256 of the conductive structure 224 and the first sidewall 248 of the first insulating layer 210. The sidewall 256 of the conductive structure 224 faces towards the first sidewall 248 of the first insulating layer 210, and the first sidewall 248 of the first insulating layer 210 faces towards the sidewall 256 of the conductive structure 224. The crevice 252 extends continuously along the first sidewall 248 of the first insulating layer 210, the sidewall 256 of the conductive structure 224, the surface 212 of the first insulating layer 210, and the surface 254 of the conductive structure 224 as shown in Figure 2. The crevice 252 overlaps a portion of the surface 208 of the conductive layer 206 such that the surface 208 of the conductive layer 206 is not fully covered by the conductive structure 224. The crevice 252 includes a crevice opening 258 that is between the surface 254 of the conductive structure 224 and the surface 212 of the first insulating layer 210.

The surface 254 includes a surface of the first conductive layer 230 and a surface of the second conductive layer 232. For example, the respective surfaces of the first conductive layer 230 and the second conductive layer 232 is substantially coplanar and flush with each other to define the surface 254 of the conductive structure 224.

A first portion 252a of the crevice 252 is substantially vertical based on the orientation as shown in Figure 2, and a second portion 252b of the crevice 252 is substantially horizontal based on the orientation as shown in Figure 2. The first portion 252a of the crevice 252 is transverse to the second portion 252b of the crevice 252. In other words, the crevice 252 has a substantially "L" like shape as shown in Figure 2. The first portion 252a of the crevice 252 is between the first sidewall 248 of the first insulating layer 210, and the second portion 252b of the crevice 252 is between the surface 254 of the conductive structure 224 and the surface 212 of the first insulating layer 210.

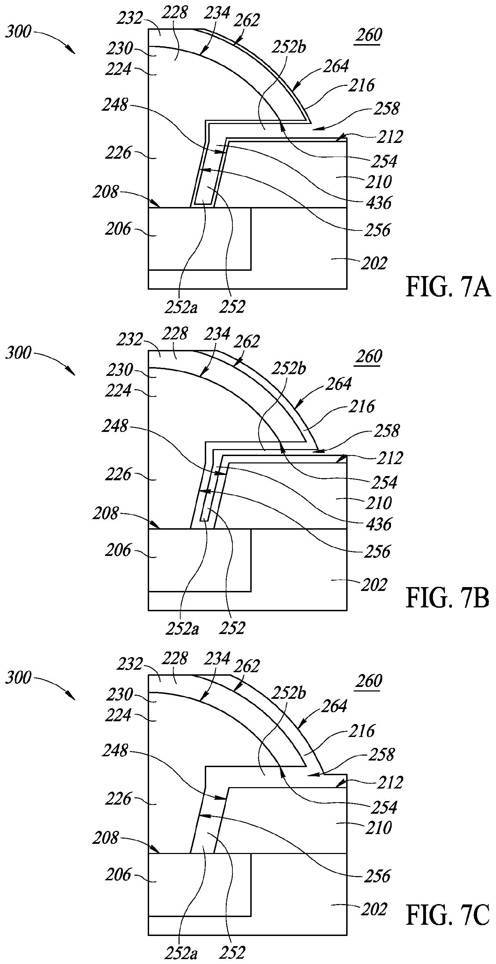

The sealing layer 216 extends into the crevice 252 through the crevice opening 258 and extends to the surface 208 of the conductive layer 206. In some embodiments, the sealing layer 216 completely fills the crevice 252 (*see, e.g.,* Figure 7C of the present invention as discussed in detail later herein). In some embodiments, the sealing layer 216 only partially fills the crevice 252 (*see, e.g.,* Figures 7A and 7B of the present invention as discussed in detail later herein). The sealing layer 216 is on and covers the portion of the surface 208 of the conductive layer 206 that is between the sidewall 256 of the conductive structure 224 and the first sidewall 248 of the first insulating layer 210. The sealing layer 216 seals the crevice 252 such that moisture (*e.g.,* gases, liquids, fluids, etc.) and contaminants (*e.g.,* chemicals, particles, etc.) from an external environment 260 external to the structure 200 may not readily enter the crevice 252 and are instead blocked and stopped by the sealing layer 216 from reaching the surface 208 of the conductive layer 206. Reducing the likelihood of the moisture and the contaminants from the external environment 260 from reaching the surface of the conductive layer 206 by covering the portion of the surface 208 of the conductive layer 206 not covered by the conductive structure 224 seals the conductive layer from the moisture and the contaminants within the external environment. Even if, the crevice 252 is not fully filled by the sealing layer 216, the sealing layer 216 is formed to completely cover the portion of the surface 208 of the conductive layer 206 that is not covered by the conductive structure 224 and the first insulating layer 210 such that while the moisture and the contaminants may enter the crevice 252 from the external environment 260, the moisture and the contaminants are blocked or stopped by the sealing layer 216 from reaching the surface 208 of the conductive layer.

This sealing of the portion of the surface 208 of the conductive layer 206 that is not covered by the conductive structure 224 and the first insulating layer 210 reduces the likelihood of corrosion or damage within the conductive layer 206. By reducing the likelihood of corrosion and damage of the conductive layer 206 with the sealing layer 216, the likelihood of corroding or damaging the conductive layer 206 during a manufacturing process or during use is reduced improving the yield of usable electronic devices that are manufactured and increasing the usable lifespan of the electronic devices manufactured with the structure 200 as shown in Figure 2 relative to other electronic devices without the sealing layer 216.

A surface 262 of the conductive structure 224 is completely covered by the sealing layer 216 such that the conductive structure is enclosed by the sealing layer 216 and the conductive layer 206 within the substrate 202. The surface 262 is a surface of the second conductive layer 232, and the surface 262 is curved in a substantially similar fashion as the surface 234 of the first conductive layer 230. The surface 262 of the conductive structure 224 faces away from the surface 204 of the substrate 202.

A surface 264 of the sealing layer 216 faces away from the conductive structure 224 and faces away from the substrate 202. The surface 264 of the sealing layer is curved in a substantially similar fashion of the surface 262 of the conductive structure 224 and the surface 234 of the first conductive layer 230 of the conductive structure 224.

In an alternative embodiment of the structure 200 as shown in Figure 2, the second insulating layer 220 is not formed on and present on the sealing layer 216. Instead, an epoxy material, a resin material, a molding compound material, or some other insulating material or non-conductive material is be formed on the sealing layer 216 instead of the second insulating layer 220 as shown in Figure 2.

The sealing layer 216 being present completely covering the surface 262 of the conductive structure 224 reduces the likelihood of corrosion in the conductive structure 224 and the conductive layer 206 when the structure 200 is being stored within a controlled environment between processing steps within a FAB or is being transported between various processing tools within the FAB. For example, by completely covering the surface 262 of the conductive structure 224 when being stored or transported with the sealing layer 408 during manufacturing within the FAB, the likelihood of corrosion propagating within the conductive structure 224 and the conductive layer 206 is reduced as environmental contaminants (*e.g.,* moisture and contaminant particles) within the external environment 260 will have greater difficulty in corroding the conductive structure 224 due to the sealing layer 408 completely covering the surface 262 of the conductive structure 224. In other words, the likelihood of corrosion in the conductive structure 224 is reduced due to the sealing layer 408 completely covering the surface 262 of the conductive structure 224.

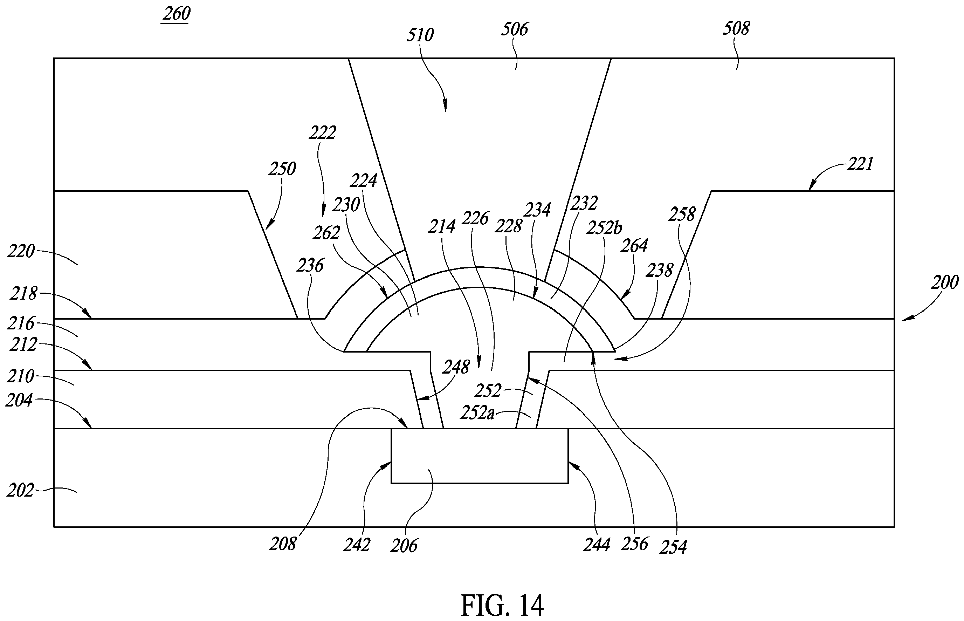

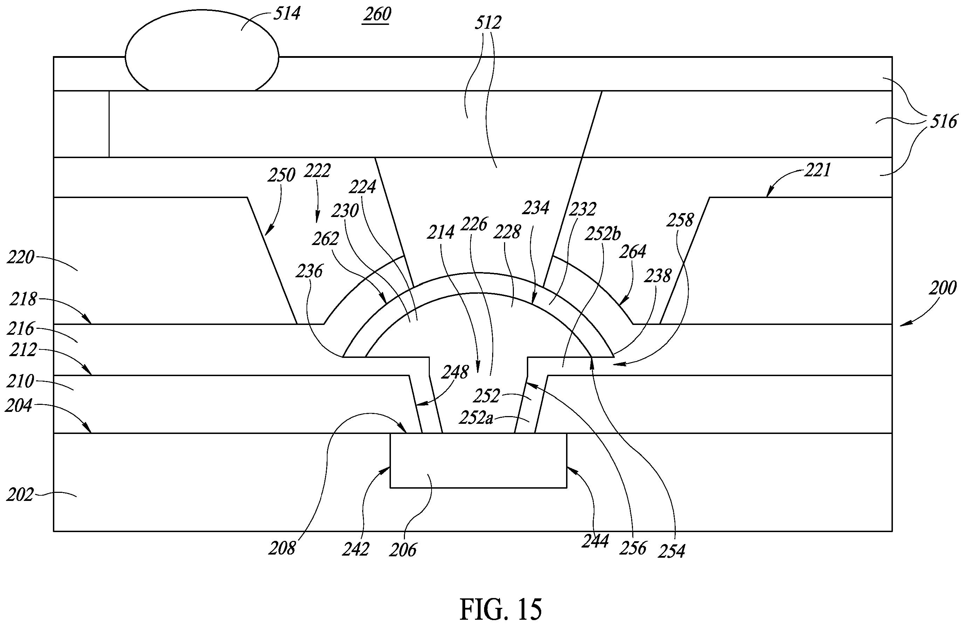

The first insulating layer 210, the sealing layer 216, and the second insulting layer 220 are formed at a front end of a manufacturing process of a semiconductor packages or devices. The sealing layer 216 completely or partially filling the crevice 252 during the front end process of manufacturing of the semiconductor devices or packages reduces the likelihood of the conductive layer 206 being corroded due to moisture and contaminants present in an external environment during further processing steps to manufacture the semiconductor package or device. The sealing layer 216 remains sealing off portions of the conductive layer 206 from the crevice 252 during further manufacturing steps to form the semiconductor device of packages. These following manufacturing steps include wire bonding formation (see wire bond formation step example in at least Figure 13 of the present invention), direct copper (Cu) interconnection formation (see direct interconnection formation example at least in Figure 15 of the present invention), direct copper (Cu) pillar formation (see copper pillar formation example at least in Figure 14 of the present invention), or some other type of manufacturing steps that follow the formation of the front end of the manufacturing process of the semiconductor packages or devices. These following manufacturing steps are, in particular, steps of a back end process of the manufacturing process to form the semiconductor devices or packages.

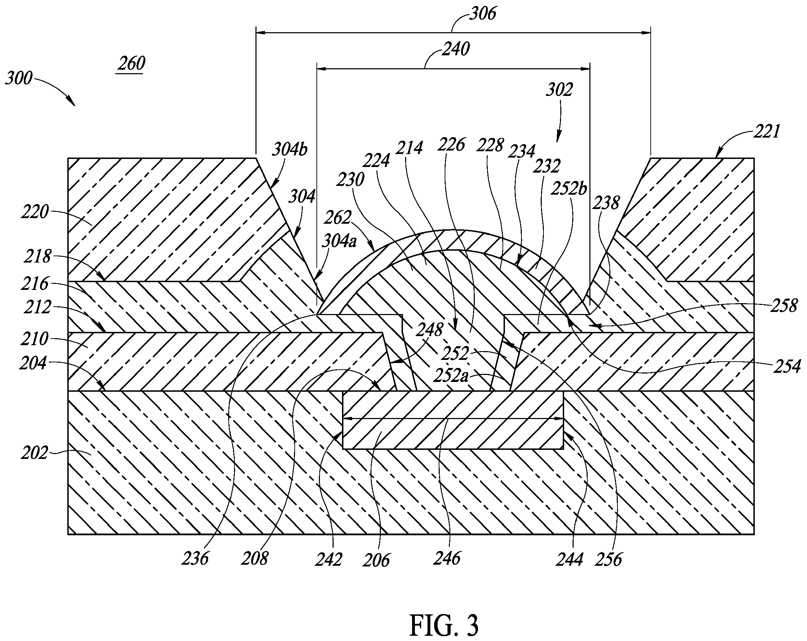

Figure 3 is a cross-sectional view of a structure 300 that may be utilized within an electronic device (*e.g.,* a semiconductor device, a semiconductor package, etc.), in accordance with at least some embodiments of the present invention. The structure 300 has a stacked configuration based on the orientation as shown in Figure 3. The structure 300 has several of the same or similar features as the structure 200 as shown in Figure 2, these features of Figure 3 that are the same or similar to features as shown and discussed above with respect to Figure 2 have the same reference numerals as those same or similar features as shown in Figure 2. For simplicity and brevity of the present invention, the following discussion of the structure 300 will focus on additional or different features in the structure 300 as shown in Figure 3 relative to the structure 200 as shown in Figure 2.

Unlike the structure 200 as shown in Figure 2, an opening 302 extends through the sealing layer 216 to the surface 262 of the conductive structure 224 as shown in Figure 3. The opening 302 exposes the surface 262 of the conductive structure 224 from the sealing layer 216. In other words, unlike the sealing layer 216 as shown in Figure 2, the sealing layer 216 does not completely and entirely cover the surface 262 of the conductive structure 224 such that the surface 262 of the conductive structure 224 is accessible through the opening 302.

As shown in Figure 3, the structure 300 includes a sidewall 304 that extends around the conductive structure 224. The sidewall 304 extends from the surface 262 of the conductive structure 224 to the surface 221 of the second insulating layer 220. The sidewall 304 includes a sidewall 304a of the sealing layer 216 and a sidewall 304b of the second insulating layer 220 that are substantially coplanar and flush with each other to define the sidewall 304. The sidewall 304 is transverse to and angled with respect to the surface 221 of the second insulating layer 220. In some embodiments, the sidewall 304 are spaced leftward and rightward from the surface 262 of the conductive structure 224 such that the sidewall 304 is not on the conductive structure surface 262 of the conductive structure 224.

The opening 302 has a dimension 306 that extends from a first side of the opening to a second side of the opening. The dimension 306 is at an upper end of the opening 302 based on the orientation as shown in Figure 3. In the embodiment of the structure 300 as shown in Figure 3, the dimension 306 is greater than the dimension 240 of the conductive structure 224 and is greater than the dimension 246 of the conductive layer 206. This opening 302 allows for the sealing layer 408 to be formed thicker relative to the sealing layer 212 as shown in Figure 2.

The first insulating layer 210, the sealing layer 216, and the second insulting layer 220 are in particular formed at a front end of a manufacturing process of a semiconductor package or device along with the opening 302. The sealing layer 216 completely or partially filling the crevice 252 during the front end process of manufacturing of the semiconductor device or package reduces the likelihood of the conductive layer 206 being corroded due to moisture and contaminants present in an external environment during further processing steps to manufacture the semiconductor package or device. The opening 302 is provided depending on the following manufacturing steps to from semiconductor devise and packages such as wire bonding formation (see wire bond formation step example in at least Figure 13 of the present invention), direct copper (Cu) interconnection formation (see direct interconnection formation example in Figure 15 of the present invention), or direct copper (Cu) pillar formation (see copper pillar formation example at least in Figure 14 of the present invention) while the sealing layer 216 still seals portions of the conductive layer 206 adjacent to the crevice 252. These following manufacturing steps are, in particular, steps of a back end process of the manufacturing process to form the semiconductor devices or packages.

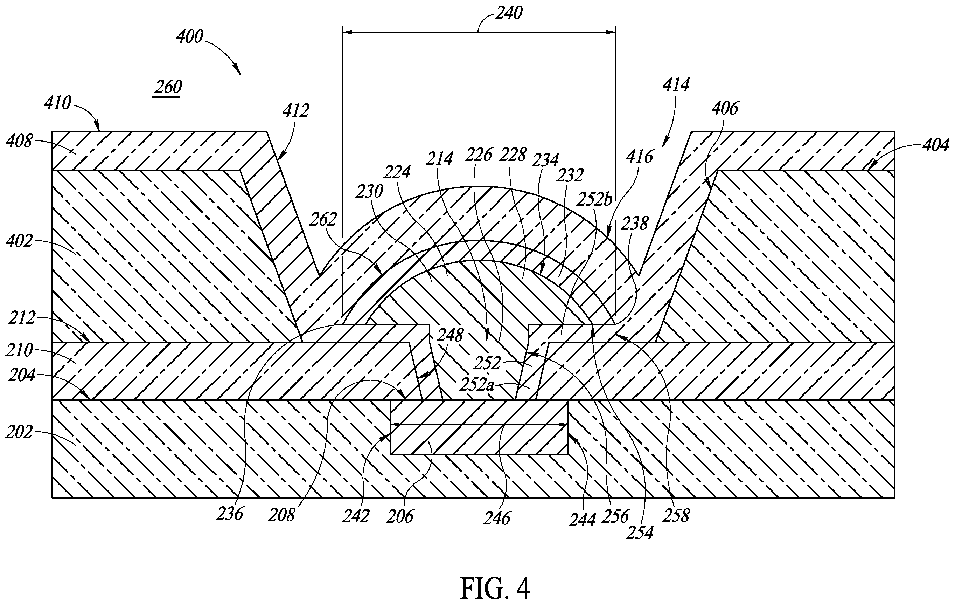

Figure 4 is a cross-sectional view of an embodiment of a structure 400 that may be utilized within an electronic device (*e.g.,* a semiconductor device, semiconductor package, etc.), in accordance with at least some embodiments of the present invention. The structure 400 has a stacked configuration based on the orientation as shown in Figure 4. The structure 400 has several of the same or similar features as the structures 200, 300 as shown in Figures 2 and 3, these features of Figure 4 that are the same or similar to the features as shown and discussed above with respect to Figures 2 and 3 have the same reference numerals as those same or similar features as shown in Figures 2 and 3. For simplicity and brevity of the present invention, the following discussion of the structure 400 will focus on additional or different features in the structure 400 as shown in Figure 4 relative to the structures 200, 300, respectively, as shown in Figures 2 and 3, respectively.

Unlike the structures 200, 300, respectively, as shown in Figures 2 and 3, respectively, a second insulating layer 402 is on the first insulating layer 210 and is on the surface 212 of the first insulating layer 210 such that the second insulating layer 402 abuts the first insulating layer 210 unlike the second insulating layer 220 as shown in Figure 2. The second insulating layer 402 includes a surface 404 that faces away from the surface 212 of the first insulating layer 210, and a sidewall 406 that extends from the surface 212 of the first insulating layer 210 to the surface 404 of the second insulating layer 402. The sidewall 406 of the second insulating layer 402 is transverse to and angled with respect to the surfaces 212, 404, respectively, of the first insulating layer 210 and the second insulating layer 402, respectively.

Unlike the structures 200, 300, respectively, as shown in Figures 2 and 3, respectively, a sealing layer 408 is on the second insulating layer 402, is on the first insulating layer 210, and is on the conductive structure 224. The sealing layer 408 has for example a thickness greater than 5-nanometers, less than 5-nanometers, or substantially equal to 5-nanometers. The sealing layer 408 is on the surface 404 of the second insulating layer 402 and completely and entirely covers the surface 404 of the second insulating layer. The sealing layer 408 is on the sidewall 406 of the second insulating layer 402 and completely and entirely covers the sidewall 406 of the second insulating layer 402. The sealing layer 408 is on a portion of the surface 212 of the first insulating layer 210 that is not covered by the second insulating layer 402 as shown in Figure 4.

A surface 410 of the sealing layer 408 faces away from the surface 404 of the second insulating layer 402. A sidewall 412 of the sealing layer 408 faces away from the sidewall 406 of the second insulating layer 402. The sidewall 412 is transverse to and angled with respect to the surface 410 of the sealing layer 408 as shown in Figure 4. The sidewall 412 are angled at substantially the same angle of the sidewall 406 when an angle of the sidewalls 406, 412, respectively, is measured from the surface 212 of the first insulating layer 210 as shown in Figure 4.

An opening 414 overlaps the conductive structure 224. The sealing layer 408 is within the opening 414 and the sidewall 412 of the sealing layers 408 extends around and surrounds the opening 414 when the opening 414 is a round opening (*e.g.,* circular, ovular, ellipsoidal, etc.). The sidewall 412 is adjacent to the opening 414.

Similar to the sealing layer 216 as shown in Figure 2, the sealing layer 408 as shown in Figure 4 is on the conductive structure 224 and completely and entirely covers the surface 262 of the conductive structure 224. The sealing layer 408 includes a surface 416 that faces away from the conductive structure 224. The surface 416 is curved in a similar fashion to the surface 262 of the conductive structure 224, and the surface 416 extends across the opening 414 between opposite sides of the opening 414.

The sealing layer 408 being present on the surface 404 and completely covering the surface 262 of the conductive structure 224 reduces the likelihood of corrosion in the conductive structure 224 and the conductive layer 206 when the structure 400 is being stored within a controlled environment between processing steps within a FAB or is being transported between various processing tools within the FAB. For example, by completely covering the surface 262 of the conductive structure 224 when being stored or transported with the sealing layer 408 during manufacturing within the FAB, the likelihood of corrosion propagating within the conductive structure 224 and the conductive layer 206 is reduced as environmental contaminants (*e.g.,* moisture and contaminant particles) within the external environment 260 will have greater difficulty in corroding the conductive structure 224 due to the sealing layer 408 completely covering the surafce 262 of the conductive structure 224. In other words, the likelihood of corrosion in the conductive structure 224 is reduced due to the sealing layer 408 completely covering the surface 262 of the conductive structure 224.

The first insulating layer 210, the second insulting layer 402, and the sealing layer 408 are, in particular, formed at a front end of a manufacturing process of a semiconductor packages or devices. The sealing layer 408 completely or partially filling the crevice 252 during the front end process of manufacturing of the semiconductor devices or packages reduces the likelihood of the conductive layer 206 being corroded due to moisture and contaminants present in an external environment during further processing steps to manufacture the semiconductor package or device. The sealing layer 408 remains sealing off portions of the conductive layer 206 from the crevice 252 during further manufacturing steps to form the semiconductor device of packages. These following manufacturing steps include wire bonding formation (see wire bond formation step example in at least in Figure 13 of the present invention), direct copper (Cu) interconnection formation (see direct interconnection formation example at least in Figure 15 of the present invention), direct copper (Cu) pillar formation (see copper pillar formation example at least in Figure 14 of the present invention), or some other type of manufacturing steps that follow the formation of the front end of the manufacturing process of the semiconductor packages or devices. These following manufacturing steps are, in particular, steps of a back end process of the manufacturing process to form the semiconductor devices or packages.

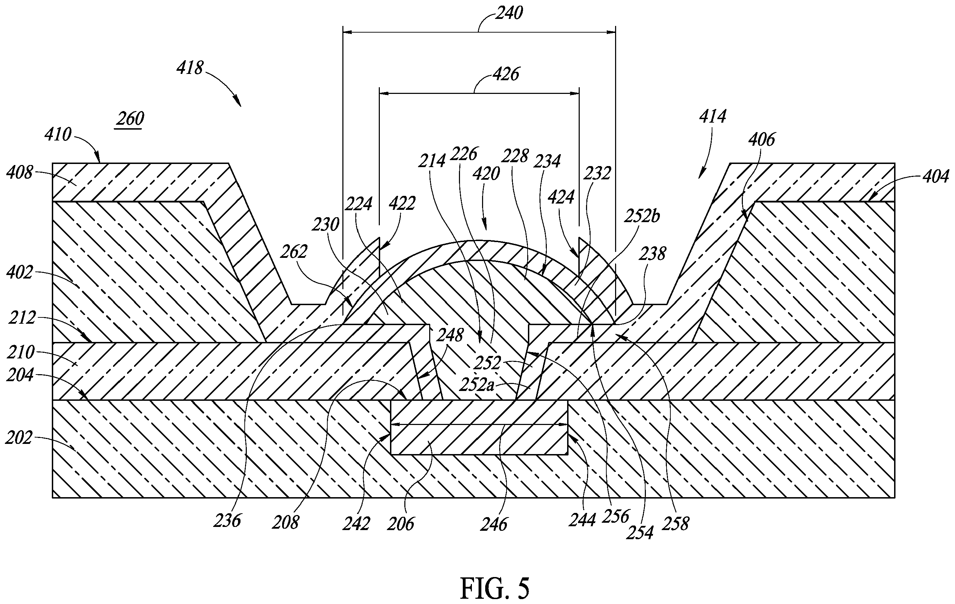

Figure 5 is a cross-sectional view of an embodiment of a structure 418 that may be utilized within an electronic device (*e.g.,* semiconductor device, semiconductor package, etc.), in accordance with at least some embodiments of the present invention. The structure 418 has a stacked configuration based on the orientation as shown in Figure 5. The structure 418 has several of the same or similar features as the structure 200, 300, 400 as shown in Figures 2, 3, and 4, these features of Figure 5 that are the same or similar to the features as shown and discussed above with respect to Figures 2, 3, and 4 have the same reference numerals as those same or similar features as shown in Figures 2, 3, and 4. For simplicity and brevity of the present invention, the following discussion of the structure 418 will focus on additional or different features in the structure 418 as shown in Figure 5 relative to the structures 200, 300, 400, respectively, as shown in Figures 2, 3, and 4, respectively.

Unlike the structure 400, the structure 418 includes an opening 420 that extends through the sealing layer 408 to the surface 262 of the conductive structure 224 such that the surface 262 of the conductive structure 224 is exposed from the sealing layer 408. A first sidewall 422 and a second sidewall 424 of the sealing layer 408 are on the surface 262 of the conductive structure 224. The first sidewall 422 is opposite to the second sidewall. In some embodiments, when the opening 420 is a round opening (*e.g.,* circular, ovular, ellipsoidal, etc.), the first and second sidewalls 422, 424, respectively, of the sealing layer 408 are portions of a single, continuous, round sidewall that extends around and surrounds the opening 420. This opening 420 allows for the sealing layer 408 to be formed thicker relative to the sealing layer 212 as shown in Figure 2.

A dimension 426 extends from the first sidewall 422 to the second sidewall 424. The dimension 426 is less than the dimension 240 of the conductive structure 224 and is greater than the dimension 246 of the conductive layer 206. In some embodiments, the dimension 426 is less than both the dimension 240 of the conductive structure 224 and the dimension 246 of the conductive layer 206.

The sealing layer 408 being present on the surface 404 and partially covering the surface 262 of the conductive structure 224 reduces the likelihood of corrosion in the conductive structure 224 and the conductive layer 206 when the structure 418 is being stored within a controlled environment between processing steps within a FAB or is being transported between various processing tools within the FAB. For example, by limiting the area of the conductive structure 224 exposed when being stored or transported with the sealing layer 408 during manufacturing within the FAB, the likelihood of corrosion propagating within the conductive structure 224 and the conductive layer 206 is reduced as environmental contaminants (*e.g.,* moisture and contaminant particles) within the external environment 260 will have greater difficulty in corroding the conductive structure due to the limited area of the conductive structure 224 exposed. In other words, the likelihood of corrosion in the conductive structure 224 is reduced due to the sealing layer 408 partially covering the surface 262 of the conductive structure 224.

The first insulating layer 210, the second insulting layer 402, and the sealing layer 408 is, in particular, formed at a front end of a manufacturing process of a semiconductor package or device along with the opening 420. The sealing layer 408 completely or partially filling the crevice 252 during the front end process of manufacturing of the semiconductor device or package reduces the likelihood of the conductive layer 206 being corroded due to moisture and contaminants present in an external environment during further processing steps to manufacture the semiconductor package or device. The opening 420 are provided depending on the following manufacturing steps to from semiconductor devise and packages such as wire bonding formation (see wire bond formation step example in at least Figure 13 of the present invention), direct copper (Cu) interconnection formation (see direct interconnection formation example at least in Figure 15 of the present invention), or direct copper (Cu) pillar formation (see copper pillar formation example at least in Figure 14 of the present invention) while the sealing layer 216 still seals portions of the conductive layer 206 adjacent to the crevice 252. These following manufacturing steps are, in particular, steps of a back end process of the manufacturing process to form the semiconductor devices or packages.

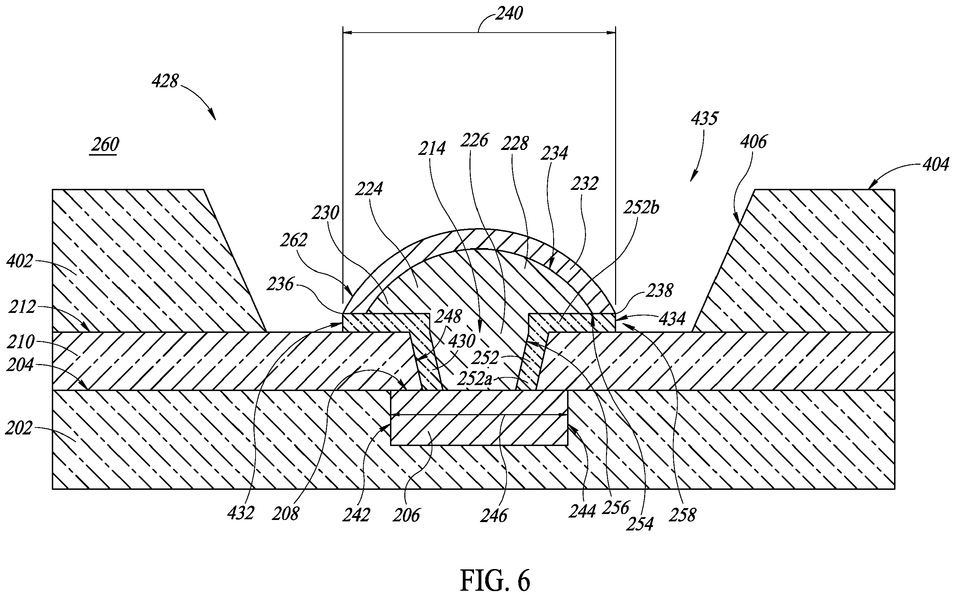

Figure 6 is a cross-sectional view of an embodiment of a structure 428 that may be utilized within an electronic device (*e.g.,* semiconductor device, semiconductor package, etc.), in accordance with at least some embodiments of the present invention. The structure 428 has a stacked configuration based on the orientation as shown in Figure 6. The structure 428 has several of the same or similar features as the structure 200, 300, 400, 418 as shown in Figures 2, 3, 4, and 5, these features of Figure 6 that are the same or similar to the features as shown and discussed above with respect to Figures 2, 3, 4, and 5 have the same reference numerals as those same or similar features as shown in Figures 2, 3, 4, and 5. For simplicity and brevity of the present invention, the following discussion of the structure 428 will focus on additional or different features in the structure 428 as shown in Figure 6 relative to the structures 200, 300, 400, 418, respectively, as shown in Figures 2, 3, 4, and 5, respectively.

Unlike the sealing layer 408 as shown in Figure 5, a sealing layer 430 is within the crevice 252, is not present on the surface 212 of the first insulating layer 210, and is not present on the surface 404 and the sidewall 406 of the second insulating layer 402. In other words, the sealing layer 430 is or extends only within the crevice 252 as shown in Figure 6. A first end surface 432 of the sealing layer 430 is at a left-hand side of the conductive structure 224 and a second end surface 434 of the sealing layer 430 is at a right-hand side of the conductive structure 224 based on the orientation as shown in Figure 6. The first end surface 432 of the sealing layer 430 is opposite to the second end surface 434 of the sealing layer 430. In some embodiments, when the first portion 226 of the conductive structure 224 is round (*e.g.,* cylindrical) then the first end surface 432 and the second end surface 434 are a single, continuous, curved surface that extends around the first portion 226 of the conductive structure 224.

An opening 435 extends through the second insulating layer 402 to the surface 212 of the first insulating layer 210 and the conductive structure 224. The sidewall 406 of the second insulating layer 402 extends around and surrounds the opening 435, and the opening 435 exposes the conductive structure 224 from the second insulating layer 402.

As shown in Figure 6, the sealing layer 430 extends around the first portion 226 of the conductive structure 224. The sealing layer has, in particular, a profile, size, and shape that is the same or similar to the profile, size, and shape as the crevice 252.

The first insulating layer 210, the second insulting layer 402, and the sealing layer 430 are, in particular, formed at a front end of a manufacturing process of a semiconductor package or device along with the opening 420. The sealing layer 430 completely or partially filling the crevice 252 during the front end process of manufacturing of the semiconductor device or package reduces the likelihood of the conductive layer 206 being corroded due to moisture and contaminants present in an external environment during further processing steps to manufacture the semiconductor package or device. The opening 435 is provided depending on the following manufacturing steps to from semiconductor devise and packages such as wire bonding formation (see wire bond formation step example in at least Figure 13 of the present invention), direct copper (Cu) interconnection formation (see direct interconnection formation example at least in Figure 15 of the present invention), or direct copper (Cu) pillar formation (see copper pillar formation example at least in Figure 14 of the present invention) while the sealing layer 430 still seals portions of the conductive layer 206 adjacent to the crevice 252. These following manufacturing steps are, in particular, steps of a back end process of the manufacturing process to form the semiconductor devices or packages.

Figure 7A is a zoomed in enhanced view of an embodiment of section 7-7 of the structure 200 as shown in Figure 2. As shown in Figure 7A, the sealing layer 216 only partially fills the crevice 252 such that an air gap 436 is present within the crevice 252. The sealing layer 216 is present on and completely covers the portion of the surface 208 of the conductive layer 206 such that the sealing layer 216 completely blocks the air gap 436 from reaching the surface 208 of the conductive layer 206. For example, even if moisture (*e.g.,* gases, liquids, fluids, etc.) and contaminants (*e.g.,* chemicals, particles, etc.) from the external environment 260 enter into the air gap 436 through the crevice opening 258 and travel along the crevice 252 towards the surface 208 of the conductive layer 206, the sealing layer 216 prevents, blocks, and stops the moisture and contaminants from reaching the surface 208 of the conductive layer 206. In other words, the sealing layer 216 acts as a barrier to prevent, block, and stop the moisture and contaminants from the external environment 260 that may readily enter the air gap 436 through the crevice opening 258. The sealing layer 216 preventing, blocking, and stopping the moisture and contaminants from the external environment 260 from reaching the surface 208 of the conductive layer 206 reduces the likelihood that the conductive layer 206 will be corroded as the moisture and contaminants cannot reach the surface 208 of the conductive layer 206.

However, only partially filling the crevice 252 such that the air gap 436 in the crevice 252 provides clearance between the conductive structure 224 and the first insulating layer 210 allows the conductive structure 224 and the first insulating layer 210 to expand into the air gap 436 when the conductive structure 224 and the first insulating layer 210 are exposed to a change in temperature (*e.g.,* an increase in temperature). For example, when coupling a wire bond or a conductive layer (see Figures 13-18 of the present invention) to the conductive structure 224, the conductive structure 224 and the first insulating layer 210 may be exposed to an increase in temperature that results in the conductive structure 224, the first insulating layer 210, or both expanding such that the surface 254 and the sidewall 256 of the conductive structure 224 and the surface 212 and the first sidewall 248 of the first insulating layer 210 move towards each other. For example, the sidewall 256 and the first sidewall 248 expand and move towards each other, and the surfaces 212, 254 move towards each other. In other words, as the conductive structure 224 and the first insulating layer 210 expand, the sidewall 256 and the surface 254 of the conductive structure 224 and the surface 212 and the first sidewall 248 of the first insulating layer 210 move and expand into the air gap 436. The air gap 436 provides clearance such that, when the conductive structure 224 and the first insulating layer 210 expands, the surface 254 and the sidewall 256 of the conductive structure 224 and the surface 212 and the first sidewall 248 of the first insulating layer 210 do not reach each other and press against each other.

This clearance provided by the air gap 436 in the crevice 252 reduces the likelihood of the propagation of mechanical issues or defects of the conductive structure 224, the first insulating layer 210, and the sealing layer 216 as when the air gap 436 provides clearance such that the expansion of the conductive structure 224, the first insulating layer 210, or both does not result in conductive structure 224, the sealing layer 216, and the first insulating layer 210 physically pressing against each other in opposite directions resulting in the propagation of mechanical issues or defects in the conductive structure 224, the sealing layer 216, and the first insulating layer 210. In other words, the air gap 436 acts as a clearance gap in the same or similar fashion as the crevice 134 as discussed above with respect to Figure 1 that is not filled by a sealing layer. By providing the sealing layer 216 in combination with the air gap 436 in the crevice 252, the air gap 436 provides clearance to reduce the likelihood of the propagation of mechanical issues or defects in the conductive structure 224, the first insulating layer 210, the sealing layer 216, as well as other layers present, while the sealing layer 216 reduces the likelihood of corrosion in the conductive layer 206 as moisture (*e.g.,* fluid, liquid, gas, etc.) and contaminants in the external environment 260 that may enter the air gap 436 are blocked or stopped by the sealing layer 216 from reaching the surface 208 of the conductive layer 206.

In view of the above discussion, not completely filling the crevice 252 with the sealing layer 216 such that the air gap 436 is present, in combination with the sealing layer 216 completely and fully covering the portion of the surface 208 of the conductive layer 206 not covered by the conductive structure 224, reduces both the likelihood of corrosion or damage in the conductive layer 206 and reduces the likelihood of mechanical issues or defects within the structure 200. However, as will become readily apparent, the sealing layer 216 in the embodiment as shown in Figure 7A is thinner than the sealing layer 216 in the embodiments as shown in Figures 7B and 7C, respectively, and, therefore, the thinner sealing layer 216 may be more readily susceptible to mechanical issues or defects when the conductive structure 224 expands relative to the thicker sealing layers 216 as shown in Figures 7B and 7C, respectively.

Figure 7B is a zoomed in enhanced view of an embodiment of section 7-7 of the structure 200 as shown in Figure 2. The embodiment as shown in Figure 7B of the sealing layer 216 has several of the same or similar features as the embodiment of the sealing layer 216 as shown in Figure 7A, these features of Figure 7B that are the same or similar to the features as shown and discussed above with respect to Figure 7A have the same reference numerals as those same or similar features as shown in Figure 7A. For simplicity and brevity of the present invention, the following discussion of the embodiment of the sealing layer as shown in Figure 7B will focus on additional or different features of the embodiment of the sealing layer 216 as shown in Figure 7B relative to the embodiment of the sealing layer 216 as shown in Figure 7A.

Unlike the embodiment of the sealing layer 216 as shown in Figure 7A, the embodiment of the sealing layer 216 as shown in Figure 7B is thicker than the embodiment of the sealing layer 216 as shown in Figure 7A. The embodiment of the sealing layer 216 as shown in Figure 7B being thicker than the embodiment of the sealing layer 216 as shown in Figure 7C results in the air gap 436 being less wide in the embodiment as shown in Figure 7B than in the air gap 436 in the embodiment as shown in Figure 7A.

With the thicker sealing layer 216 as shown in Figure 7B, even if mechanical issues or defects propagated within the sealing layer 216 due to expansion of the conductive structure 224, the mechanical issues or defects likely will not stop the sealing layer 216 from sealing and protecting to the surface 208 of the conductive layer 206. The mechanical issues or defects not preventing the sealing layer 216 from protecting and sealing the surface 208 of the conductive layer 206 due to the increased thickness of the sealing layer 216 reduces the likelihood of corrosion or damage in the conductive layer 206 as the moisture and contaminants from the external environment 260 cannot readily reach the surface 208 of the conductive layer 206. However, as the air gap 436 as shown in Figure 7B is less wide than the air gap 436 as shown in Figure 7A, the air gap 436 as shown in Figure 7B provides less clearance than the wider air gap 436 as shown in Figure 7A. The less wide air gap 436 as shown in Figure 7B may slightly increase the likelihood of the respective surfaces of the sealing layer 216 pressing against each other due to the expansion in the conductive layer 206, which may slightly increase the likelihood of the propagation of mechanical issues or defects in the conductive structure 224, the first insulating layer 210, the sealing layer 216, or other layers that are present. In other words, the thickness of the sealing layer 216 is balanced against the width of the air gap 436.

Figure 7C is a zoomed in enhanced view of an embodiment of section 7-7 of the structure 200 as shown in Figure 2. The embodiment as shown in Figure 7C of the sealing layer 216 has several of the same or similar features as the embodiments of the sealing layers 216 as shown in Figures 7A and 7B, these features of Figure 7C that are the same or similar to the features as shown and discussed above with respect to Figures 7A and 7B have the same reference numerals as those same or similar features as shown in Figures 7A and 7B. For simplicity and brevity of the present invention, the following discussion of the embodiment of the sealing layer as shown in Figure 7C will focus on additional or different features of the embodiment of the sealing layer 216 as shown in Figure 7C relative to the embodiments of the sealing layer 216 as shown in Figures 7A and 7B.

As shown in Figure 7C, in this embodiment of the sealing layer 216, the crevice 252 is completely and entirely filled with the sealing layer 216 such that the air gap 436 present in Figures 7A and 7B is not present in the embodiment as shown in Figure 7C. In view of the sealing layer 216 completely and entirely filling the crevice 252, the likelihood of the moisture and contaminants from the external environment 260 reaching the conductive layer 206 is further reduced as the crevice 252 is completely and entirely filled by the sealing layer 216. However, the sealing layer 216 may be more readily susceptible to the propagation of mechanical issues or defects when the conductive structure 224 expands due to being exposed to changes in temperature.

In view of the above discussions with respect to Figures 7A, 7B, and 7C, the air gap 436 is provided or not provided depending on the thickness that the sealing layer 216 is formed to have such that the air gap 436 is present in the embodiment as shown in Figures 7A and 7B, and the air gap 436 not being present in the embodiment as shown in Figure 7C. It will be readily appreciated that the various thicknesses of the sealing layer 216 and the air gap 436 readily also apply with respect to the structures 300, 400, 418, 428 as shown in Figures 3-6 of the present invention.

In view of the above discussion with respect to Figures 7A, 7B, and 7C, one of the various embodiments of the sealing layer 216 can be selected depending on balancing factors such as, but not limited to, the changes of temperature the conductive structure may be exposed to, the amount of moisture and contaminants in the external environment 260, the types of environmental qualities of the external environment 260, or other similar or like factors that can be considered when determining whether to provide the air gap 436 by forming the sealing layer 216 with one of the various thicknesses as shown in Figures 7A, 7B, and 7C of the present invention.

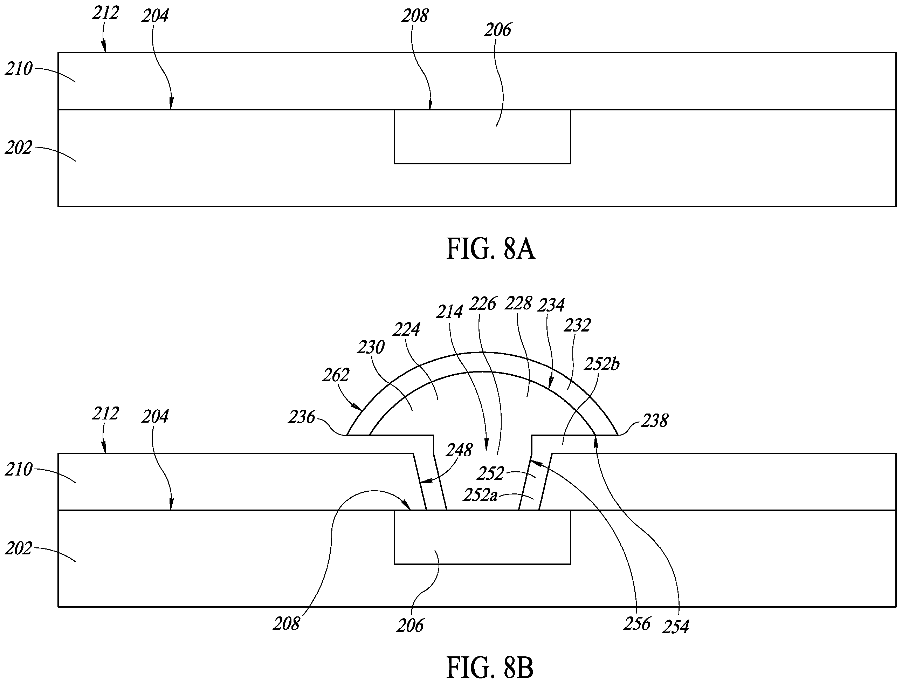

Figures 8A-8D are directed to an embodiment of a method of manufacturing the embodiment of the structure 200 as shown in Figure 2 of the present invention. Figures 8A-8D are cross-sectional views of a structure after various steps of the embodiment of the method of manufacturing the structure 200 as shown in Figure 2.

Figure 8A is a cross-sectional view of a step of the embodiment of the method of manufacturing the structure 200 in which the first insulating layer 210 is formed on the surface 204 of the substrate 202 and the surface 208 of the conductive layer 206. The first insulating layer 210 is in particular a passivation layer that includes a passivation material. The first insulating layer 210 is, in this case, formed by a passivation technique. Forming the first insulating layer 210 includes completely covering the surface 204 of the substrate 202 and completely covering the surface 208 of the conductive layer 206 within the substrate 202.

After the first insulating layer 210 is formed on the surfaces 204, 208 of the substrate 202 and the conductive layer 206, respectively, as shown in Figure 8A, the first opening 214 is formed to extend through the first insulating layer 210 to the surface 208 of the conductive layer 206 followed by forming the conductive structure 224 within the first opening 214 and on the surface 208 of the conductive layer 206. The first opening 214 is formed by patterning the first insulating layer 210. For example, a temporary layer (not shown) is formed on the surface 212 of the first insulating layer 210 and completely covers the surface 212 of the first insulating layer 210. The temporary layer is for example a temporary resist layer, a temporary sacrificial layer, or some other similar or like type of temporary layer. If the temporary layer is a resist layer, a mask is positioned over the resist layer and the resist layer is patterned with an opening that is aligned with and overlaps the conductive layer 206 by exposing the mask and the resist layer to a light source, which is for example an ultraviolet light source. Once the opening in the resist layer is formed that is aligned with and overlaps the conductive layer 206, the mask is removed from the resist layer and an etchant is introduced to the opening in the resist layer to etch away or remove a portion of the first insulating layer 210. Exposing the etchant to the first insulating layer 210 through the opening in the resist layer, forms the first opening 214 extending through the first insulating layer 210 to the surface 208 of the conductive layer 206. Once the first opening 214 is formed, the resist layer is removed from the surface 212 of the first insulating layer. Forming the first opening 214 results in forming the first sidewall 248 of the first insulating layer 210.

After the resist layer is removed and after the first opening 214 is formed, the conductive structure 224 is formed in the first opening 214 and on the surface 208 of the conductive layer 206. The conductive structure 224 is for example formed by a conductive material deposition or formation technique (*e.g.,* ion beam deposition, conductive material growth, electroless material deposition or growth, or some other similar or like type of conductive material deposition or formation technique.). For example, when the conductive structure 224 is formed by an electroless deposition technique, the conductive material is deposited and grown on the surface 208 of the conductive layer 206 by placing the first insulating layer 210 in which the first opening 214 is present and the substrate 202 within a chemical bath in which a chemical reaction occurs forming and growing the first conductive layer 230 of the conductive structure 224 on the surface 208 of the conductive layer 206. After the first conductive layer 230 is formed with the electroless deposition technique, the second conductive layer 232 is formed on the surface 234 of the first conductive layer 230 by a plating technique (*e.g.,* a chemical plating technique, an electroplating technique, or some other similar or like type of plating technique). For example, when the plating technique is an electroplating technique, the substrate 202, the first insulating layer 210, and the first conductive layer 230 are positioned with an electroplating solution through which an electrical current is passed plating the surface 234 of the first conductive layer 230 with the second conductive layer 232. Forming the first conductive layer 230 with the electroless deposition technique does not adhere the first conductive layer 230 to the first sidewall 248 of the first insulating layer 210.

After this electroplating technique is performed, the second conductive layer 232 covers the surface 234 of the first conductive layer 230 and is coupled to the first conductive layer 230 forming the conductive structure 224. After the first conductive layer 230 and the second conductive layer 232 are formed to form the conductive structure 224, the crevice 252 is also formed by forming the conductive structure 224 as shown in Figure 8B.

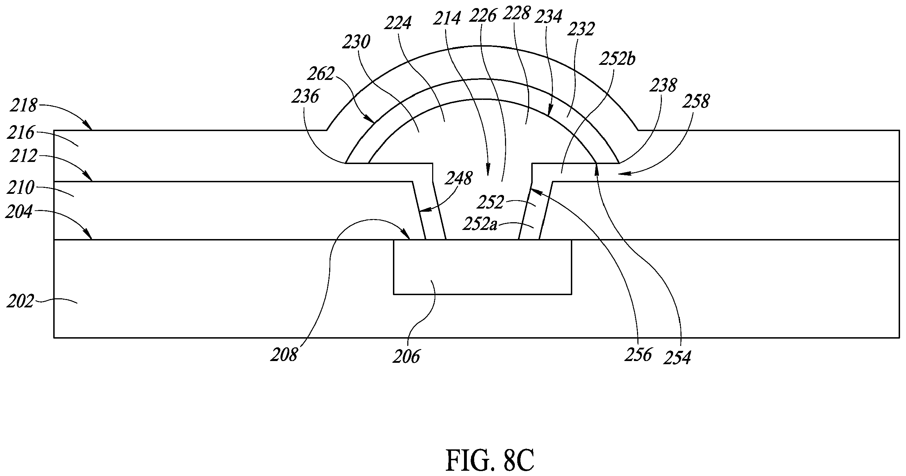

After the first opening 214 in the first insulating layer 210 and the conductive structure 224 are formed as shown in Figure 8B, the sealing layer 216 is formed as shown in Figure 8C. The sealing layer 216 is formed by an atomic layer deposition (ALD) technique or process. ALD is a vapor phase technique used to deposit thin films onto a substrate. The process of ALD involves, in an embodiment, the surface of a substrate being exposed to alternating precursors, which do not overlap but instead are introduced sequentially. In each alternate pulse, the precursor molecule reacts with the surface in a self-limiting way, this ensures that the reaction stops once all of the reactive sites on the substrate have been used. A complete ALD cycle is determined by the nature of the precursor-surface interaction. The ALD cycle can be performed multiple times to increase the layers of the thin film, depending on the requirement. The process of ALD is often performed at lower temperatures, which is beneficial when working with substrates that are fragile, and some thermally unstable precursors can still be employed with ALD as long as their decomposition rate is slow. A wide range of materials can be deposited using ALD, including oxides, metals, sulfides, and fluorides, and there is a wide range of properties that these coatings can exhibit, depending on the application.

Utilizing the ALD technique or process forms the sealing layer 216 to cover the portion of the surface 208 of the conductive layer 206 with the sealing layer such that the moisture or contaminants from an external environment that may enter the crevice 252 cannot readily reach the conductive layer 206. Utilizing this ALD technique or process forms the varying thicknesses of the sealing layer 216 as shown and discussed in detail earlier herein with respect to Figures 7A, 7B, and 7C of the present invention. In some other embodiments of the method of manufacturing the structure 200, the sealing layer 216 is formed by some other process or technique that allows for the sealing layer 216 to completely and entirely cover the portion of the surface 208 of the conductive layer 206 that is not covered by the conductive structure 224.

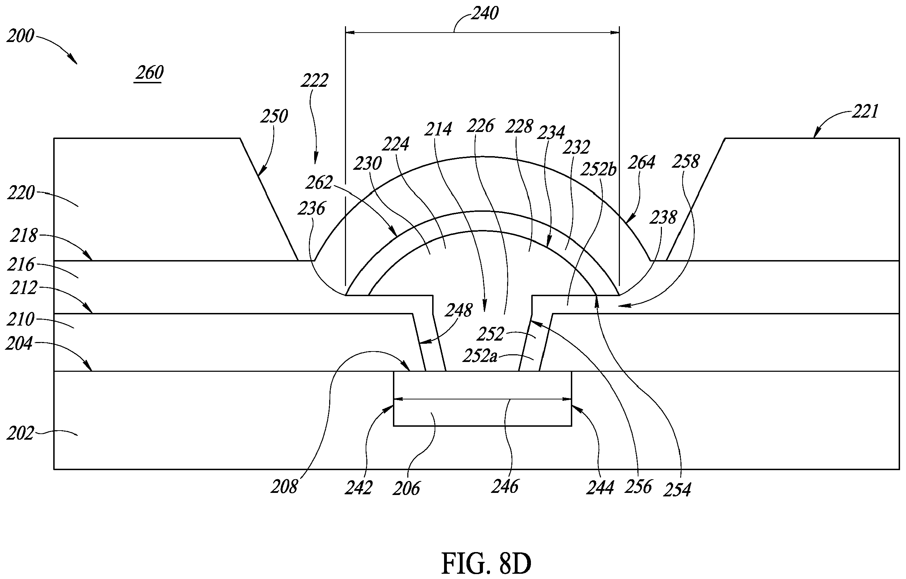

After the sealing layer 216 is formed as shown in Figure 8C, the second insulating layer 220 is formed on the surface 218 of the sealing layer 216 as shown in Figure 8D. Forming the second insulating layer 220 includes utilizing a deposition technique such as a sputtering technique, a mask technique, an injection technique, or some other similar or like type of deposition technique that may be utilized to form the second insulating layer 220. For example, a temporary layer (not shown) is formed on the sealing layer 216. The temporary layer is for example a temporary resist layer, a temporary sacrificial layer, or some other similar or like type of temporary layer. If the temporary layer is a resist layer, a mask is positioned over the resist layer and the resist layer is patterned by exposing the resist layer to a light (*e.g.,* ultraviolet light) that passes through the mask. After patterning the resist layer, a portion of the resist layer remains on the surface 264 of the sealing layer 216 and covers the surface 264 of the sealing layer 216. Once the resist layer has been patterned such that the portion of the resist layer remains covering the surface 264 of the sealing layer 216, the second insulating layer 220 is formed on the sealing layer 216 at areas that are not covered by the resist layer. After the second insulating layer 220 has been formed, the portion of the resist layer on and covering the surface 264 is removed forming the second opening 222 that extends through the second insulating layer 220 to the surface 264 of the sealing layer 216. After this resist layer is removed, the structure 200 as shown in Figure 2 is formed. It will be readily appreciated that the structure 200 as shown in Figure 8D is a reproduction of the structure 200 as shown in Figure 2 for discussion purposes of the method of forming the structure 200 as discussed in detail above.

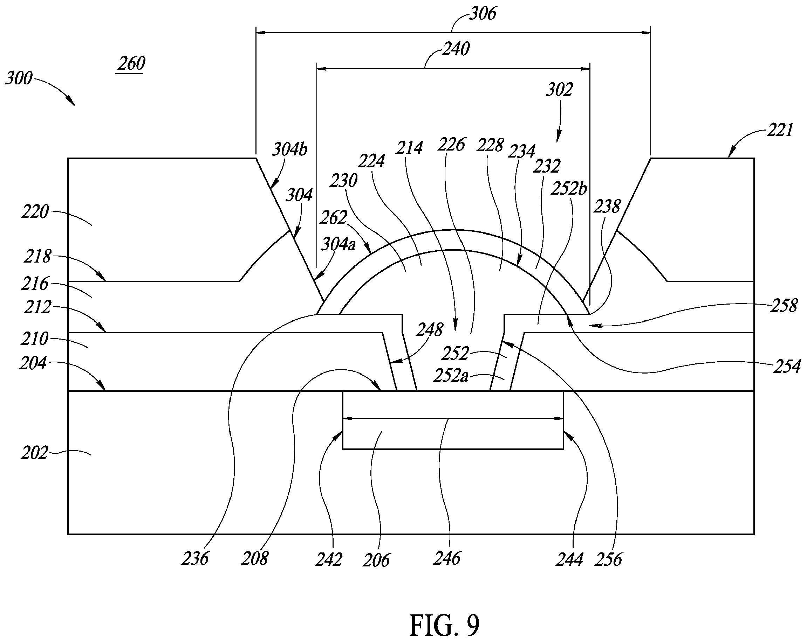

Figure 9 is directed to an embodiment of a method of manufacturing the structure 300 as shown in Figure 3. Figure 9 is a reproduction of the structure 300 as shown in Figure 3 for purposes of discussing the embodiment of the method of manufacturing the structure 300.

The embodiment of the method of manufacturing the structure 300 is the same or similar as the method of manufacturing the structure 200 as discussed above with respect to Figures 8A-8D. However, there is an additional step to form the opening 302 after the step carried out as shown in Figure 8D has been completed.

The opening 302 is formed by removing a portion of the sealing layer 216 aligned with the second opening 222 as shown in Figure 8D. The portion of the sealing layer 216 is, for example, removed by exposing the sealing layer 216 to an etchant through the second opening 222 removing the portion of the sealing layer 216 forming the opening 302 and exposing the surface 262 of the conductive structure 224 from the sealing layer 216. In some embodiments, the portion of the sealing layer 216 is removed by some other technique rather than exposing the sealing layer to the etchant. Forming the opening 302 also forms the third sidewall 304 that includes the sidewall 304a of the sealing layer 216 and the sidewall 304b of the second insulating layer 220.

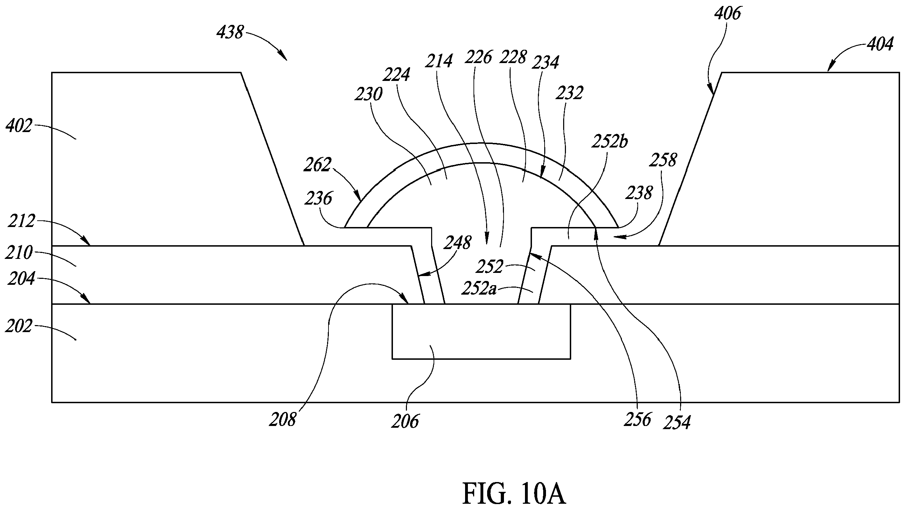

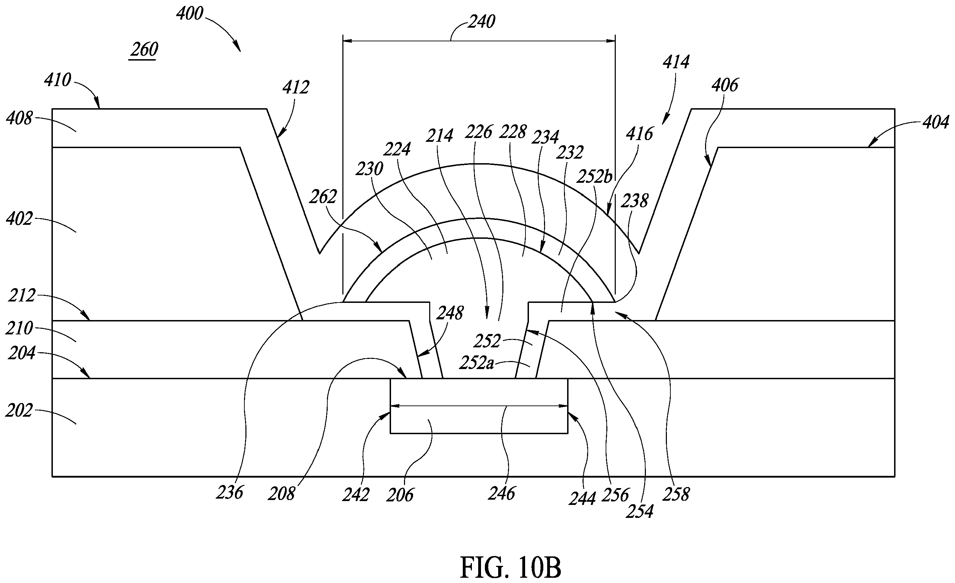

Figures 10A and 10B are directed to an embodiment of a method of manufacturing the structure 400 as shown in Figure 4 of the present invention. Figures 10A and 10B are cross-sectional views of a structure after various steps of the embodiment of the method of manufacturing the structure 400 as shown in Figure 4.

In the embodiment of the method of manufacturing the structure 400, the steps as discussed above with respect to Figures 8A and 8B are carried out when forming the structure 200. However, after the conductive structure 224 is formed, the second insulating layer 402 is formed on the first insulating layer 210 before the sealing layer 408. The second insulating layer 402 is formed not to fill the crevice 252 or cover the conductive structure 224. Instead, an opening 438 is formed that extends through the second insulating layer 402 to the conductive structure 224 and the surface 212 of the first insulating layer 210 such that the conductive structure 224 is exposed from the second insulating layer 402.

In some embodiments, the second insulating layer 402 is formed in the same or similar manner as the second insulating layer 220 as discussed above with respect to Figure 8D. In some alternative embodiments, the second insulating layer 402 is a photosensitive material or is an etchant sensitive material. For example, when the second insulating layer 402 is an etchant sensitive material, the second insulating layer 402 is formed covering the conductive structure 224 and within the crevice 252. After the second insulating layer 402 is formed covering the conductive structure 224 and within the crevice 252, the second insulating layer 402 is exposed to an etchant to form the opening 438 and remove the second insulating layer 402 formed within the crevice 252.

After the second insulating layer 402 is formed as shown in Figure 10A, the sealing layer 408 is formed on the conductive structure 224, in the crevice 252, and on the second insulating layer 402. The sealing layer 408 is formed with the ALD process as discussed above with respect to forming the sealing layer 216 with respect to Figure 8C. Forming the sealing layer 408 results in covering the sidewall 406 of the second insulating layer 402 and the conductive structure 224 with the sealing layer 408. Forming the sealing layer 408 forms the sidewall 412 of the sealing layer 408 and forms the opening 414 as well.

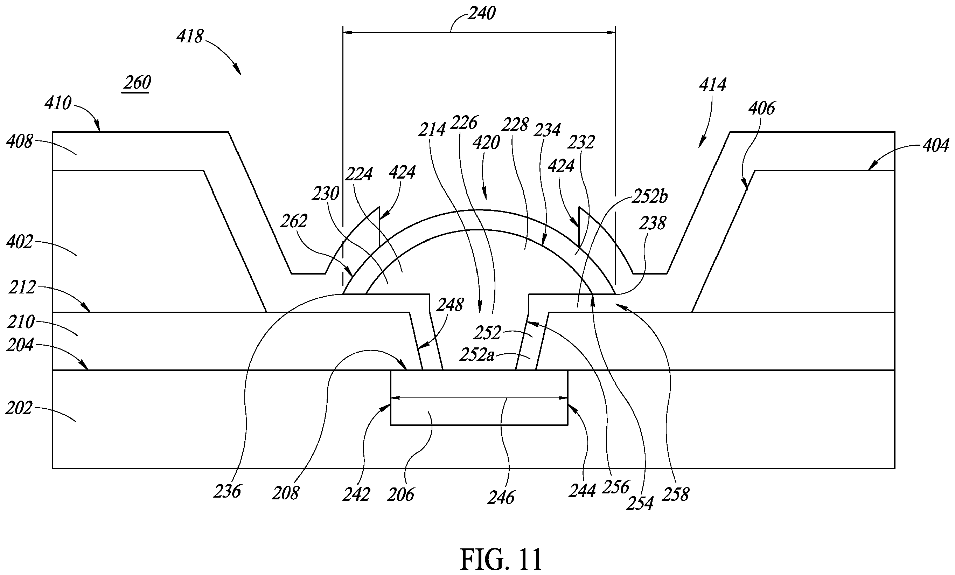

Figure 11 is directed to an embodiment of a method of manufacturing the structure 418 as shown in Figure 5. Figure 11 is a reproduction of the structure 418 as shown in Figure 5 for purposes of discussing the embodiment of the method of manufacturing the structure 418.

The embodiment of the method of manufacturing the structure 418 is the same or similar as the method of manufacturing the structure 400 as discussed above with respect to Figures 10A and 10B. However, there is an additional step to form the opening 420 after the step carried out as shown in Figure 10B has been completed.

The opening 420 is formed by removing a portion of the sealing layer 408 on the surface 262 of the conductive structure 224. The portion of the sealing layer 408 is for example removed by exposing the sealing layer 408 to an etchant through the opening 414 removing the portion of the sealing layer 408 on the conductive structure 224 and exposing the surface 262 of the conductive structure 224 from the sealing layer 408. In some embodiments, the portion of the sealing layer 408 is removed by some other technique rather than exposing the sealing layer to the etchant. Forming the opening 420 also forms the first sidewall 422 and the second sidewall 424 that are on the surface 262 of the conductive structure 224.

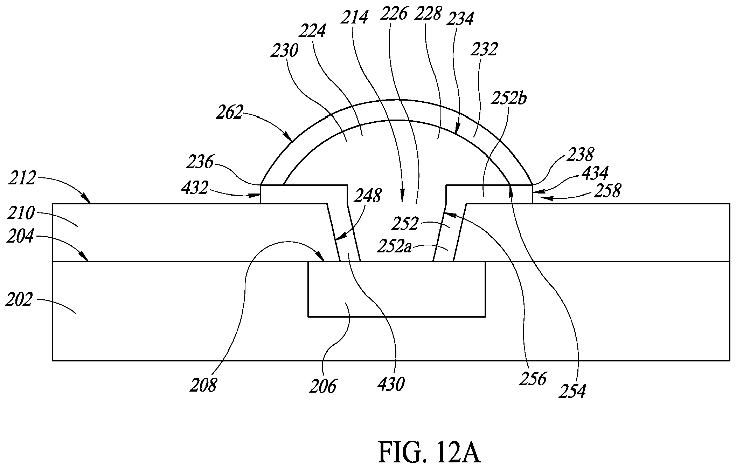

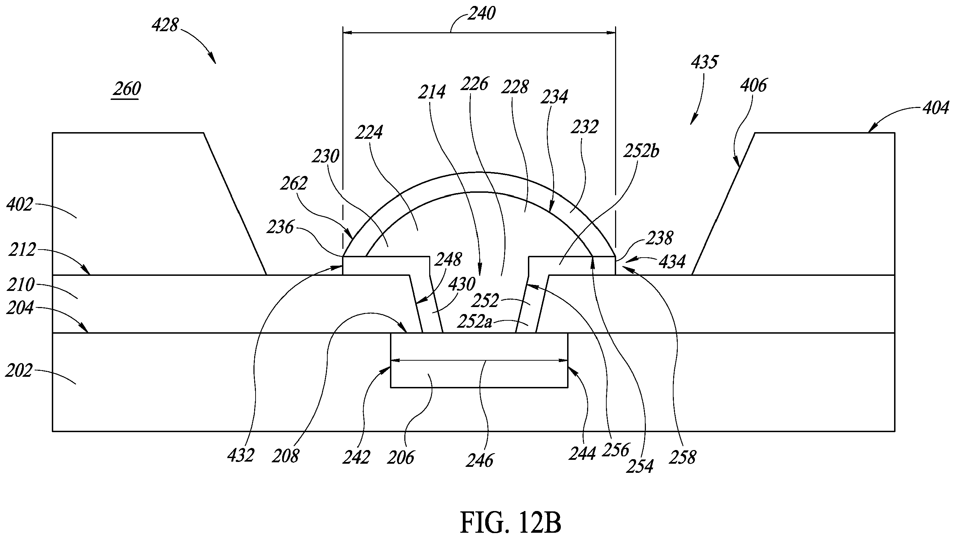

Figures 12A and 12B are directed to an embodiment of a method of manufacturing the structure 428 as shown in Figure 6. Figure 12B is a reproduction of the structure 428 as shown in Figure 6 for purposes of discussing the embodiment of the method of manufacturing the structure 428.

The embodiment of the method of manufacturing the structure 428 is the same or similar as the method of manufacturing the structure 200 up to Figure 8B. However, there are additional steps to form the structure 400 after following the steps up to Figure 8B.

The sealing layer 430 is formed on the surface 212 of the first insulating layer 210 and is formed within the crevice 252 between the conductive structure 224 and the first insulating layer 210. The sealing layer 430 is formed with the ALD technique or process as discussed above with respect to forming the sealing layer 216 as shown in Figure 8C. After the sealing layer 430 is formed on the surface 212 of the first insulating layer 210 and within the crevice 252, the sealing layer 430 is partially removed to expose areas of the surface 212 of the first insulating layer 210 while leaving the sealing layer 430 present within the crevice 252. Leaving the sealing layer 430 within the crevice 252 allows for the sealing layer 430 within the crevice to remain covering the portion of the surface 208 of the conductive layer 206 that is not covered by the conductive structure 224. Leaving the sealing layer 430 within the crevice 252 results in forming the first end surface 432 and the second end surface 434 of the sealing layer 430. The first end surface 432 being at the first point 236 and the second end surface 434 being at the second point 238.

After the sealing layer 430 has been formed and is then removed such that the sealing layer 430 remains only within the crevice 252, a second insulating layer 402 is formed on the surface 212 of the first insulating layer 210 such that the sidewall 406 of the second insulating layer 402 extends around and surrounds the opening 435. As discussed earlier, the opening 435 exposes the conductive structure 224 from the second insulating layer 402. The second insulating layer 402 is formed in the same or similar manner as the second insulating layer 402 as discussed above with respect to Figure 10A.

In an alternative embodiment of the method of manufacturing the structure 428 as discussed above with respect to Figures 12A and 12B, the steps up to Figure 10B are carried out and then additional steps are carried out to form the structure 428. For example, the sealing layer 408 is formed on a temporary layer, which is the same or similar material to the second insulating layer 402 and has a structure similar to the second insulating layer 402 as shown in Figure 4, that is on the surface 212 of the first insulating layer 210. The sealing layer 408 is formed to fill the crevice 252 as shown in Figure 10B. After the sealing layer 408 is formed on the temporary layer and within the crevice 252, the temporary layer is removed and a portion of the sealing layer 408 is removed to form the sealing layer 430 as shown in Figure 12A by etching away the temporary layer and the portion of the sealing layer 408. Etching the temporary layer and the sealing layer 408 results in exposing the surface 212 of the first insulating layer 210 and leaving the sealing layer 430 as shown in Figure 12A in the crevice 252. After the temporary layer and the portion of the sealing layer 408 are removed, which results in the formation of the sealing layer 430, the second insulating layer 402 is formed on the surface 212 of the first insulating layer 210 forming the structure 428 as shown in Figure 12B.

As it is readily apparent in view of the above discussion, forming embodiments of the structures 300, 418, 428 as shown in Figures 3, 5, and 6 may be more expensive to manufacture as compared to manufacturing embodiments of the structures 200, 400 as shown in Figures 2 and 4. For example, Figure 3, 5, and 6 may have more steps in embodiments of methods of manufacturing the structures 300, 400, 418, 428 relative to embodiments of methods of manufacturing the structures 200, 400 as shown in Figures 2 and 4. For example, forming the structures 300, 500, 600 include forming the openings 302, 420, 435, respectively, which are formed by an additional step (*e.g.,* etching step) as compared to forming the structures 200, 400.

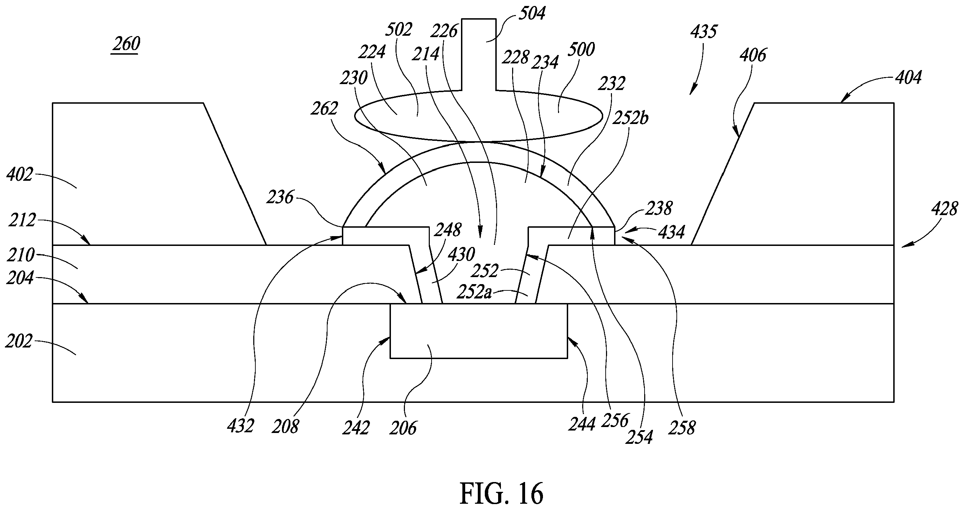

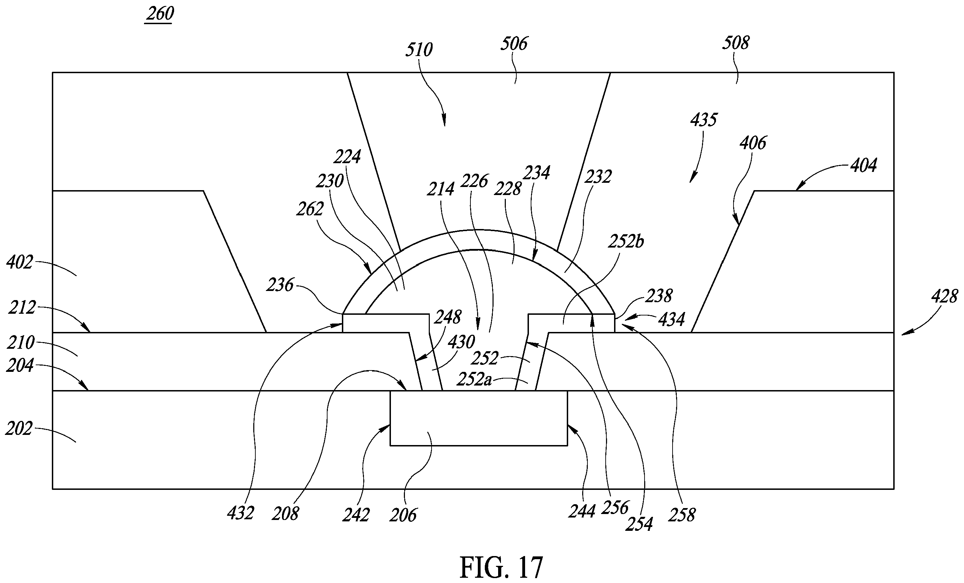

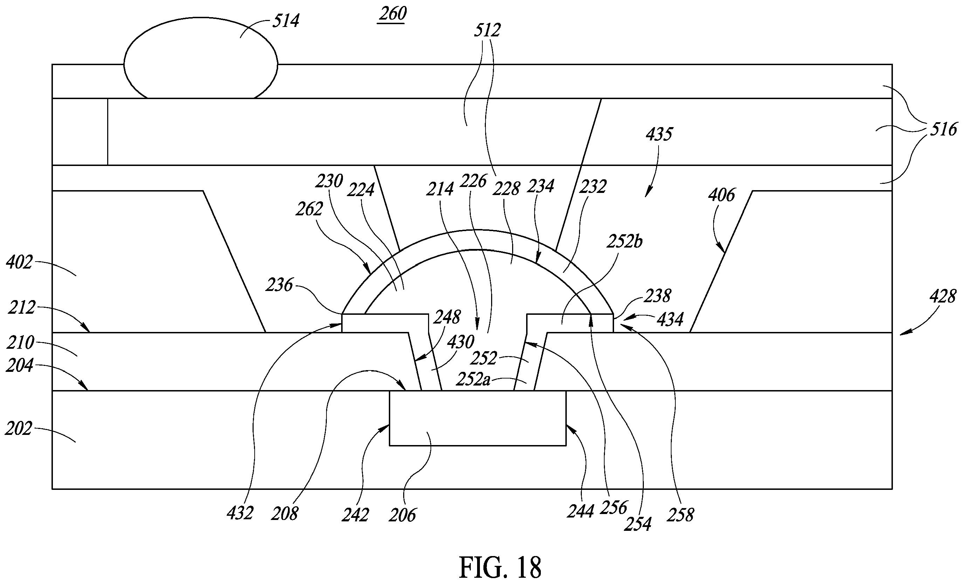

While forming the structures 300, 418, 428, respectively, may be more expensive or costly as compared to manufacturing the structures 200, 400, the openings 302, 420, 435 may more readily provide access to the conductive structure 224 such that a bonding wire (see bonding wire 502 as shown in Figures 13 and 16), a conductive layer (*e.g.,* see conductive layer 506 as shown in Figures 14 and 17), or at least one of a plurality of conductive layers (see plurality of conductive layers 512 as shown in Figures 15 and 18) are more readily coupled to the conductive structure 224. For example, the sealing layer 216, 403 does not fully cover or is not present on the surface 262 of the conductive structure 224 as shown in Figures 3, 5 and 6 such that the bonding wire, the conductive layer, or the at least one of the plurality of conductive layerscome into direct, physical contact with the surface 262 of the conductive structure 224 when being formed without having to contact the sealing layers 216, 403, respectively, at the beginning of forming the bonding wire, the conductive layer, or the plurality of conductive layers to the conductive structure 224. This direct, physical contact forms a more robust coupling between the bonding wire, the conductive layer, or at least one of the plurality of conductive layers to the conductive structure 224 as compared to instead when the surface 262 of the conductive structure 224 is fully covered by the sealing layers 216, 403, respectively.

Figure 13 is directed to a wire bond 500 coupled to the conductive structure 224 of the structure 200 as shown in Figures 2 and 8D of the present invention. The wire bond 500 is, for example, formed by a wire bond formation technique (*e.g.,* a ball and stitch technique). The wire bond 500 includes an end 502, which is referred to as a ball end or a ball, and a wire 504 that is coupled to the end 502 and extends away from the end 502. The wire 504 extends to an electrical feature, structure, or component to which the wire 504 is coupled to form an electrical pathway between the conductive structure 224 and the electrical feature, structure, or component. The electrical pathway is utilized to pass electrical signals between the conductive structure 224 and the electrical feature, structure, or component.

When forming and coupling the wire bond 500 to the conductive structure 224, forming the wire bond 500 on the surface 264 of the sealing layer 216 deteriorates, dissolves, or destroys a portion of the sealing layer on the surface 262 of the conductive structure 224 such that the end 502 of the wire bond 500 is in electrical communication with the conductive structure 224. For example, the wire bond 500 is at a temperature that deteriorates, dissolves, or destroys the portion of the sealing layer 216 such that the end 502 extends through the sealing layer 216 to the conductive structure 224. This deterioration or destruction of the portion of the sealing layer 216 is possible as the sealing layer 216 is relatively thin as compared to the overall size and thickness of the conductive structure 224 and the wire bond 500.

While forming the wire bond 500 to couple the end 502 to the conductive structure, the conductive structure 224 on the conductive layer 206 expands as the conductive structure 224 is exposed to a change in temperature (*e.g.,* an increase in temperature). For example, when the air gap 436 is present and when the conductive structure 224 is exposed to a change in temperature (*e.g.,* an increase in temperature), the conductive structure 224 expands into the air gap 436 of the crevice 252. This expansion of the conductive structure 224 results in the conductive structure 224 such that the sidewall 256 of the conductive structure 224 moves towards the first sidewall 248 of the first insulating layer 210 and the surface 254 of the conductive structure 224 moves towards the surface 212 of the first insulating layer 210. As the conductive structure 224 expands and the sidewall 256 and the surface 254 of the conductive structure 224 move, the conductive structure 224 expands into the air gap 436 and the sidewall 256 and the surface 254 of the conductive structure 224 move into the air gap 436. The air gap 436 provides clearance such that when the conductive structure 224 expands the conductive structure 224 does not reach the first sidewall 248 and the surface 212 of the first insulating layer 210. This reduces the likelihood of the propagation of mechanical issues or defects in the conductive structure 224, the first insulating layer 210, and the sealing layer 216 as when the air gap 436 provides clearance such that the expansion of the conductive structure 224 does not result in conductive structure 224, the sealing layer 216, and the first insulating layer 210 physically pressing against each other in opposite directions resulting in the propagation of mechanical issues or defects in the conductive structure 224, the sealing layer 216, and the first insulating layer 210. In other words, the air gap 436 acts as a clearance gap in the same or similar fashion as the crevice 134 as discussed above with respect to Figure 1 that is not filled by a sealing layer.

The air gap 436 of the crevice 252 as discussed above extends to the sealing layer 216 on the conductive layer 206 such that the sealing layer 216 is adjacent to the end of the crevice 252. The sealing layer 216 acts as a barrier and blocks or stops the moisture and contaminants that entered the air gap 436 through the crevice opening 258 and traveled along the air gap 436 of the crevice 252 to the sealing layer 216 from reaching the conductive layer 206. This at least reduces the likelihood of the conductive layer being corroded or damaged by being exposed to the moisture and contaminants in the external environment 260 that may enter the air gap 436 through the crevice opening 258 while forming the wire bond 500. By reducing the likelihood of corrosion or damage of the conductive layer while manufacturing the electronic devices (e.g., in a FAB), the yield of usable electronic devices that are manufactured within preferred tolerances is increased.

Alternatively, when the air gap 436 is not present as shown in Figure 7C, the sealing layer 216 still prevents, blocks, and stops the moisture and contaminants from the external environment 260 from reaching the conductive layer 206. When the sealing layer 216 fully fills the crevice 252 such that the air gap 436 is not present as shown in Figure 7C, the likelihood of the moisture and contaminants from the external environment 260 when forming the wire bond 500 is further reduced as compared to when the air gap 436 is present as shown in Figures 7A and 7B. However, when the air gap 436 is not present as the sealing layer 216 fully fills the crevice 252, the conductive structure 224, the first insulating layer 210, and the sealing layer 216, there is a slight increase in the likelihood of the propagation of mechanical issues or defects in the conductive structure 224, the first insulating layer 210, and the sealing layer 216, relative to the likelihood of the propagation of mechanical issues or defects in the conductive structure, the first insulating layer 210, and the sealing layer 216 when the air gap 436 is present.

Figure 14 is a cross-sectional view of the structure 200 with a conductive layer 506 coupled to the conductive structure 224. The conductive layer 506 extends through a third insulating layer 508, which is for example an epoxy material, a resin material, a molding compound material, a polyimide material, or some other similar or like insulating material that can be utilized to form the third insulating layer 508. In some embodiments, the third insulating layer 508 is made of the same material as the second insulating layer 220 such that the third insulating layer 508 when formed on the second insulating layer 402 seems to be, or actually is, a single, continuous layer of insulating material.

The third insulating layer 508 is formed on the second insulating layer 220 and formed in the second opening 222 such that the third insulating layer 508 covers the surface 221 and the sidewall 250 of the second insulating layer 220 and covers the surface 264 of the sealing layer 216. The third insulating layer 508 is for example formed by an injection molding technique, a compression molding technique, or some other similar or like technique for forming the third insulating layer 508. After the third insulating layer 508 is formed, the third insulating layer 508 is patterned with an opening 510 in which the conductive layer 506 is formed. The opening 510 is formed to expose the surface 264 of the sealing layer 216 from the third insulating layer 508. While the third insulating layer 508 is shown as being a single layer in Figure 14, in some embodiments, the third insulating layer 508 includes one or more layers of insulating layers stacked on each other based on the orientation as shown in Figure 14.

Once the opening 510 is formed, a conductive material is introduced into the opening 510 and allowed to cure to form the conductive layer 506. The conductive material introduced within the opening deteriorates, dissolves, or destroys a portion of the sealing layer 216 such that the conductive material comes into contact with the conductive structure 224 as shown in Figure 14. This deterioration and destruction of the portion of the sealing layer 216 was discussed in detail with respect to forming the wire bond 500 as shown in Figure 13, and, therefore, the details of this deterioration and destruction of the portion of the sealing layer 216 are not reproduced here for simplicity and brevity of the present invention. Also, forming the conductive layer 506 results in the conductive structure 224 expanding in the same or similar manner when forming the wire bond, and, therefore, the details of this expansion of the conductive structure 224 are not reproduced here for simplicity and brevity of the present invention.

Figure 15 is a cross-sectional view of the structure 200 in which a plurality of conductive layers 512 with one of the plurality of conductive layers 512 being coupled to the conductive structure 224, and a solder ball 514 is coupled to one of the plurality of conductive layers 512. A plurality of third insulating layers 516 extends around the plurality of conductive layers 512, and the solder ball 514 extends through the plurality of third insulating layers 516 and is coupled to one of the plurality of conductive layers 512. The plurality of conductive layers 512 are, in particular, portions of or form a redistribution layer (RDL) within the plurality of third insulating layers 516.

The plurality of conductive layers 512 and the plurality of third insulating layers 516 are formed by performing the process discussed above with respect to forming the conductive layer 506 and the third insulating layer 508 more than once to form additional ones of the plurality of conductive layers 512 and additional ones of the plurality of third insulating layers 516. After the plurality of conductive layers 512 and the plurality of third insulating layers 516 are formed in the stacked configuration based on the orientation as shown in Figure 15, an opening is formed in the upper most one of the plurality of third insulating layers 516 in which the solder ball 514 is formed by a solder ball formation technique within the opening coupling the solder ball 514 to the upper most one of the plurality of conductive layers 512. The solder ball 514 is then utilized to mount the structure as shown in Figure 15 to an external electrical component, structure, or device (*e.g.,* a printed circuit board, another semiconductor device or package, or some other similar or like type of electronic component, structure, or device to which the structure as shown in Figure 15 may be mounted or coupled).

Figure 17 is a cross-sectional view of the structure 428 as shown in Figures 6 and 12B of the present invention with the wire bond 500 coupled to the conductive structure 224 of the structure 428. The wire bond 500 is formed and coupled to the conductive structure 224 of the structure 428 in the same or similar manner as discussed above with respect to coupling the wire bond 500 to the conductive structure 224 of the structure 200 as shown in Figure 14. Accordingly, for brevity and simplicity sake of the present invention, the details of forming and coupling the wire bond 500 to the conductive structure 224 on the structure 428 are not discussed in detail herein.

Figure 18 is a cross-sectional view of the structure 428 as shown in Figures 6 and 12B of the present invention with the plurality of conductive layers 512 coupled to the conductive structure 224 of the structure 428. The plurality of conductive layers 512 are within the plurality of third insulating layers 516 and the solder ball 514 is coupled to the upper most one of the plurality of conductive layers 512 based on the orientation as shown in Figure 18. The plurality of conductive layers 512, the solder ball 514, and the plurality of third insulating layers 516 are formed in the same or similar manner as discussed above with respect to forming the plurality of conductive layers 512, the solder ball 514, and the plurality of third insulating layers 516 as discussed above with respect to Figure 16. Accordingly, for brevity and simplicity sake of the present invention, the details of forming the plurality of conductive layers 512, the solder ball 514, and the plurality of third insulating layers 516 on the structure 428 are not discussed in detail herein.

While not shown, the wire bond 500 is formed and coupled to the conductive structure 224 of the structures 300, 400, 418 when one of the structures 300, 400, 418 as shown in Figures 3, 4, and 5, respectively, is utilized instead of the structures 200, 428 as shown in Figures 2 and 6, respectively. For example, the end 502 of the wire bond 500 is on and coupled to the conductive structure 224 of one of the structures 300, 400, 418 such that the end 502 of the wire bond 500 extends through one of the sealing layers 216, 408 to the conductive structure 224 of the structures 300, 400, 418.

While not shown, the plurality of conductive layers 512, the solder ball 514, and the plurality of third insulating layers 516 are formed on the structure 400 when one of the structures 300, 400, 418 as shown in Figures 3, 4, and 5, respectively, is utilized instead of the structures 200, 428 as shown in Figures 2 and 6, respectively. For example, the plurality of third insulating layers 516 are formed on one of the sealing layers 216, 408 and cover one of the sealing layers 216, 408, the plurality of conductive layers 512 are formed in the plurality of third insulating layers 516 with the lower most one of the plurality of conductive layers 512 extending through one of the sealing layers 216, 408 and coupled to the conductive structure 224, and the solder ball 514 is formed to extend through the upper most one of the plurality of third insulating layers 516 to the upper most one of the plurality of conductive layers 512.

As shown in Figure 3, the opening 302 is present and extends through the second insulating layer 220 and the sealing layer 216 to the surface 262 of the conductive structure 224. The opening 302 is formed before coupling the wire bond 500 or the lower most one of the plurality of conductive layers 512 to the conductive structure 224 such that the conductive material utilized to form the wire bond 500 or the lower most one of the plurality of conductive layers 512 are at a lower temperature relative to when the sealing layer 216 is on and covering the surface 262 of the conductive structure 224 as shown in the structure 200 in Figure 2. In other words, the opening 302 more readily provides access to the conductive structure 224 such that the temperature of the conductive material utilized to form the wire bond 500 or the lower most one of the plurality of conductive layers 512 is at a lower temperature reducing the overall expansion of the conductive structure 224 relative to when the sealing layer 216 covers the conductive structure 224 of the structure 200 as shown in Figure 2. This reduction in temperature that results in the reduction in overall expansion of the conductive structure 224 of the structure 300 when forming the wire bond 500 or the plurality of conductive layers 512 further reduce the likelihood the propagation of mechanical issues or defects in the various layers and structures of the structure 300 relative to when forming the wire bond or the plurality of conductive layers 512 on the structure 200.

As shown in Figure 5, the opening 420 is present and extends through the sealing layer 408 to the surface 262 of the conductive structure 224. The opening 420 is formed before coupling the wire bond 500 or the lower most one of the plurality of conductive layers 512 to the conductive structure 224 such that the conductive material utilized to form the wire bond 500 or the lower most one of the plurality of conductive layers 512 are at a lower temperature relative to when the sealing layer 408 is on and covering the surface 262 of the conductive structure 224 as shown in the structure 400 in Figure 4. In other words, the opening 420 more readily provides access to the conductive structure 224 such that the temperature of the conductive material utilized to form the wire bond 500 or the lower most one of the plurality of conductive layers 512 is at a lower temperature reducing the overall expansion of the conductive structure 224 relative to when the sealing layer 408 covers the conductive structure 224 of the structure 400 as shown in Figure 4. This reduction in temperature that results in the reduction in overall expansion of the conductive structure 224 of the structure 418 when forming the wire bond 500 or the plurality of conductive layers 512 further reduce the likelihood of the propagation of mechanical issues or defects in the various layers and structures of the structure 400 relative to when forming the wire bond or the plurality of conductive layers 512 on the structure 400.

In view of the above discussion, it should be readily apparent that the air gap 436 within the crevice 252 provides clearance such that the conductive structure 224 expands when exposed to a change in temperature. Accordingly, the crevice 252 provides clearance to reduce the likelihood of the propagation of mechanical issues or defects in various layers that make up the embodiment of the structures as discussed herein.

In view of the above discussion, it should be readily apparent that the sealing layers 216, 408, 430 within the crevice 252 provide protection or a barrier against moisture and contaminants from an external environment reaching the conductive layer 206 within the substrate 202. Accordingly, the sealing layers 216, 408, 430 provide protection and act as barriers to reduce the likelihood of corrosion or damage in the conductive layer 206 within the substrate 202 by preventing the moisture and contaminants from the external environment from reaching the conductive layer 206 within the substrate 202.

The structures 200, 300, 400, 418, 428 as shown in Figures 2-6 and other similar or like embodiments of the structures 200, 300, 400, 418, 428 may be utilized in electronic devices. These electronic devices include, for example, semiconductor packages, semiconductor devices, semiconductor structures, or other or similar like electronic devices. For example, these semiconductor package or semiconductor devices can be BMOS (Bi-Polar Metal Oxyd Semiconductors), CMOS (Complementary Metal Oxide Semiconductors), DMOS (Double Diffused Metal Oxide Semiconductors), or some other similar or like type of semiconductor packages, semiconductor devices, semiconductor structures, or electronic devices in which the structures 200, 300, 400, 418, 428 or embodiments of the structures 200, 300, 400, 418, 428 are utilized.

In some embodiments, the respective sealing layers 216, 408, 430 and the respective crevices 252 as shown in Figures 2-6 are less wide than as shown in Figures 2-6. For example, the respective crevices 252 are less wide such that the sealing layers 216, 408, 430 are thinner.

A device may be summarized as including a substrate including a first surface; a conductive layer within the substrate, the conductive layer including a second surface exposed from the first surface of the substrate; a first insulating layer on the first surface of the substrate, the first insulating layer having a first sidewall transverse to the first surface of the substrate and the second surface of the conductive layer; a first opening extending through the first insulating layer to the second surface of conductive layer, the first opening is adjacent to the first sidewall of the first insulating layer; a conductive structure is in the first opening, is on the second surface of the conductive layer, and is coupled to the conductive layer, the conductive structure includes a second sidewall that faces the first sidewall and is spaced apart from the first sidewall of the first insulating layer; a crevice is between the first sidewall of the first insulating layer and the second sidewall of the conductive structure, the crevice extends along the first sidewall of the first insulating layer and the second sidewall of the conductive structure to the second surface of the conductive layer; and a sealing layer is within the crevice and is on the second surface of the conductive structure to seal the second surface of the conductive structure from an environment external to the crevice.

In one embodiment, the sealing layer completely fills the crevice. In another embodiment, the sealing layer partially fills the crevice.

The conductive structure may further include a first portion that extends from the second surface in a first direction transverse to the second surface; and a second portion that extends from the first portion in a second direction transverse to the first portion, the second portion including a third surface that faces away from the first surface of the substrate and the second surface of the conductive layer.

In one embodiment, the sealing layer is on the third surface of the conductive structure. In another embodiment, the sealing layer completely covers the third surface of the conductive structure.

A second opening may extend through the sealing layer to the third surface of the conductive structure, the opening exposing the third surface from the sealing layer.

The first portion of the conductive material may include a first conductive material; the second portion of the conductive material may include the first conductive material and a second conductive material; and the third surface may be a surface of the second conductive material.

The device may further include a second insulating layer on the first insulating layer, and wherein the sealing layer is on the second insulating layer.

The first insulating layer may include a third surface that faces away from the first surface of the substrate; and the sealing layer may be on the third surface of the first insulating layer, and the sealing layer may include a fourth surface that faces away from the third surface of the first insulating layer.

The device may further include a second insulating layer on the fourth surface of the insulating layer.

In one embodiment, the sealing layer may be between the first insulating layer and the second insulating layer. In another embodiment, the sealing layer may completely separate the first insulating layer from the second insulating layer.

Alternatively to the above, a device according to the present invention may be summarized as including a substrate; a first conductive layer in the substrate, the first conductive layer includes a surface exposed from the substrate; a conductive structure includes a first end coupled to the first conductive layer; an insulating layer around the conductive structure, the insulating layer is spaced apart from the conductive structure; and a sealing layer is on the surface of the first conductive layer and extends along the surface of the first conductive layer from the insulating layer to the conductive structure.

The device may further include a crevice between the insulating layer and the conductive structure, the crevice extending to the sealing layer on the surface of the first conductive layer, and wherein the sealing layer completely separates the surface of the first conductive layer from the crevice.

The device may further include a wire bond coupled to the conductive structure, and wherein the second conductive structure includes a second end opposite to the first end, the second end of the conductive structure being coupled to the wire bond.

The device may further include a second conductive layer coupled to the conductive structure, and wherein the second conductive structure includes a second end opposite to the first end, the second conductive structure being coupled to the second conductive layer.

A method may be summarized as including forming a first insulating layer with an opening exposing a surface of a conductive layer at a surface of a substrate; and coupling a conductive structure to the conductive layer by forming the conductive structure in the opening and on the surface of the conductive layer, coupling the conductive structure to the conductive layer includes forming a crevice extending from a first sidewall of the first insulating layer to a second sidewall of the conductive structure and extending to the surface of the conductive layer, and sealing the surface of the conductive layer from the crevice by forming a sealing layer in the crevice and on the surface of the conductive layer separating the crevice from the surface of the conductive layer.

The sealing layer may be formed by an atomic layer deposition technique.

Forming the sealing layer may further include forming the sealing layer on the first sidewall of the first insulating layer and on the second sidewall of the conductive structure.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled.

## Claims

1. A device (200; 300; 400), comprising:
a substrate (202);
a conductive layer (206) within the substrate, the conductive layer including a surface (208) exposed from the substrate;
a conductive structure (224) including a first end coupled to the first conductive layer;
a first insulating layer (210) around the conductive structure, the insulating layer being spaced apart from the conductive structure (224) by a crevice; and
a sealing layer (216; 408; 430) extending through the crevice towards the surface of the conductive layer.

2. The device of claim 1, wherein:
the substrate (202) includes a first surface (204);
the conductive layer (206) includes a second surface (208) exposed from the first surface (204) of the substrate; and
the first insulating layer (210) is on the first surface of the substrate, the first insulating layer having a first sidewall (248) transverse to the first surface of the substrate and the second surface of the conductive layer,
the device (200; 300; 400) further including a first opening (214) extending through the first insulating layer to the second surface of conductive layer, the first opening being adjacent to the first sidewall of the first insulating layer,
and wherein:
the conductive structure (224) is in the first opening, is on the second surface of the conductive layer, and is coupled to the conductive layer, the conductive structure includes a second sidewall (256) that faces the first sidewall and is spaced apart from the first sidewall of the first insulating layer;
the crevice (252) is between the first sidewall (248) of the first insulating layer (210) and the second sidewall (256) of the conductive structure (224), and extends along the first sidewall of the first insulating layer and the second sidewall of the conductive structure to the second surface of the conductive layer; and
the sealing layer (216; 408; 430) is within the crevice and is on the second surface of the conductive structure to seal the second surface of the conductive structure from an environment external to the crevice.

3. The device of claim 1 or claim 2, wherein the sealing layer (216; 408; 430) fills partially or completely the crevice (252).

4. The device of anyone of the preceding claims, wherein the conductive structure (224) further includes:
a first conductive portion (226) that abuts from the second surface (208) in a first direction; and
a second conductive portion (228) that extends on and in direct contact with the first portion (226), the second conductive portion including a third surface (262) that faces away from the first surface (204) of the substrate and the second surface (208) of the conductive layer.

5. The device of claim 4, wherein the second conductive portion (228) extends from the first conductive portion (226) in a second direction transverse to the first portion, the third surface (262) being a curved surface.

6. The device of claim 5, wherein the sealing layer (216; 408) is on the third surface (262) of the conductive structure.

7. The device of claim 6, wherein the sealing layer (216; 408; 430) completely covers the third surface (262) of the conductive structure.

8. The device of claim 6 or claim 7, wherein a second opening (420) extends through the sealing layer (262) to the third surface of the conductive structure, the second opening (420) exposes the third surface from the sealing layer.

9. The device of anyone of claims 4-8, wherein:
the first conductive portion (226) includes a first conductive material;
the second conductive portion (228) includes the first conductive material and a second conductive material different from the first conductive material; and
the third surface is a surface of the second conductive material.

10. The device of anyone the preceding claims, further comprising a second insulating layer (402) on the first insulating layer (210), and wherein the sealing layer (408) is on the second insulating layer.

11. The device of anyone of claims 1-9, wherein the sealing layer (216) is on the first insulating layer (210), and the sealing layer (216),
the device further comprising a second insulating layer (220) on the sealing layer (216).

12. The device of claim 11, wherein the sealing layer (216) completely separates the first insulating layer (210) from the second insulating layer (220).

13. A method for manufacturing a device (200; 300; 400), comprising:
forming a first insulating layer (210) with an opening exposing a surface of a conductive layer (206) at a surface of a substrate (202); and
forming a conductive structure (224) on and in electrical contact with the conductive layer by forming the conductive structure in the opening and on the surface of the conductive layer,
the step of forming the conductive structure includes:
forming a crevice (252) extending from a first sidewall of the first insulating layer to a second sidewall of the conductive structure and extending to the surface of the conductive layer; and
sealing the surface of the conductive layer from the crevice by forming, in particular utilizing an ALD technique, a sealing layer (216; 408; 430) in the crevice and on the surface of the conductive layer separating the crevice from the surface of the conductive layer.

14. The method of claim 13, wherein forming the conductive structure (224) includes forming the conductive structure spaced apart from the first insulating layer (210), thereby forming said crevice.

15. The method of claim 13 or 14, wherein forming the sealing layer (216; 408; 430) further comprises forming the sealing layer on the first sidewall of the first insulating layer and on the second sidewall of the conductive structure.

16. The method of anyone of claims 13-15, wherein forming the conductive structure (224) includes:
forming a first conductive portion (226) extending from the second surface (208) in a first direction; and
forming a second conductive portion (228) on and in direct contact with the first portion (226), the second conductive portion including a curved surface (262) that faces away from the first surface (204) of the substrate and the second surface (208) of the conductive layer.
